# EUROPEAN PATENT SPECIFICATION

(11) **EP 2 648 381 B1**
(45) Date of publication and mention of the grant of the patent: **13.02.2019**
(21) Application number: 13162111.2
(22) Date of filing: 03.04.2013
(51) Int. Cl.: H04L 27/00

(54) **Method and apparatus for a data rate controller for a code block multiplexing scheme**
Verfahren und Vorrichtung für eine Datenratensteuerung für ein Codeblock-Multiplexing-Schema
Procédé et appareil pour un contrôleur de débit de données dans un schéma de multiplexage de blocs de code

(30) Priority: 03.04.2012 US 201213438570
(43) Date of publication of application: 09.10.2013
(73) Proprietor: Hughes Network Systems, LLC, Germantown, MD 20876 (US)
(72) Inventor: Qin, Liming, Gaithersburg, MD Maryland 20878 (US); Adas, Marwan, Broadlands, VA Virginia 20148 (US); Raikar, Prachi, Germantown, MD Maryland 20874 (US); Roos, David, Boyds, MD Maryland 20841 (US); Antia, Yezdi, North Potomac, MD Maryland 20878 (US); Becker, Neal, Frederick, MD Maryland 21702 (US)
(74) Representative: Potter Clarkson

(56) References cited:
- EP-A2- 2 512 054
- US-A1- 2011 258 669

## Description

### BACKGROUND

Transportation of higher throughput advanced services via a satellite transponder has been an engineering design constraint for decades. The transmission system and receiver system are main two areas of a satellite broadcast system. High capacity data services over satellite are among the primary technology challenges facing the industry and satellite system operators today. Digital video broadcast - satellite second generation (DVB-S2) is an enhanced specification for satellite digital television broadcast developed in 2003 and ratified in March 2005. Using the traditional mechanism over the standard DVB-S2, meeting the high bandwidth and interactive services requires significantly higher satellite transponders to support data rates.

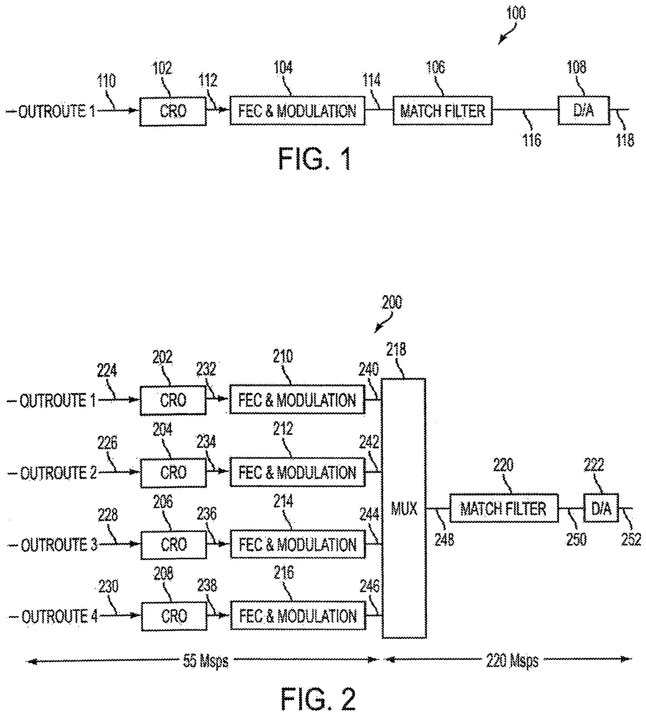

**FIG. 1** illustrates an example conventional transmitter.

As illustrated in the figure, a transmitter **100** includes a code rate organizer (CRO) **102,** a modulator **104,** a match filter **106** and a digital-to-analog converter (DAC) **108.**

CRO **102** may be arranged to receive an outroute stream signal **110** and output a signal **112.** Modulator **104** may be arranged to receive signal **112** and output a modulated signal **114.** Match filter **106** may be arranged to receive modulated signal **114** and output a transmit signal **116.** DAC **108** may be arranged to receive transmit signal **116** and output an analog signal **118.**

CRO **102** may determine the modulation and coding to be performed for outroute stream signal **110** in order to generate output signal **112.** CRO **102** may perform coding for information to be communicated to remote receivers (not shown) as addressed by outroute stream signal **110.**

Modulator **104** may encode received signal **112** and output modulated signal **114.** Modulator **104** may code a digital data input payload for ensuring a receive terminal can decode and perform error correction for errors occurring in a received payload.

Match filter **106** may perform filtering in order to maximize the signal-to-noise ratio of a signal in the presence of an additive noise.

DAC **108** may convert digital modulated transmit signal **116** to analog signal **118.**

In operation, CRO **102** may receive and perform coding for received signal outroute stream signal **110.** Modulator **104** may receive signal **112** and perform forward error correction and modulation. Match filter **106** may receive signal which has been coded, forward error corrected and modulated and perform filtering on the received signal in order to maximize the signal-to-noise ration of the signal in the presence of additive noise. Finally, DAC **108** may convert the coded, forward error corrected, modulated and filtered signal into an analog continuous waveforms for transmission.

In a conventional satellite system, data streams may be coded, modulated and broadcast to a multiplicity of mobile terminals. A typical conventional transmitter can receive a signal with up to 45 million symbols per second (Msps). However, in order to meet the demand for today's high definition and advanced services, terminals may be required to support significantly more than the 45 Msps. To achieve high data rates, for example up to 220 Msps, needed by the satellite communications industry using conventional techniques would require expensive equipment with significantly high power consumption.

What is needed is a system and method to increase the efficiency and address the challenges of transmitting high quality video and advanced services via satellite in a cost effective manner while adhering to low power consumption constraints.

US2011/0258669A1 describes a transmitter for use with a first input signal and a second input signal. The transmitter includes a first modulating portion, a second modulating portion and a multiplexing portion. The first modulating portion can output a first plurality of code blocks based on the first input signal, wherein each of the first plurality of code blocks has a first sequence number associated therewith and is modulated with a first modulation scheme. The second modulating portion can output a second plurality of code blocks based on the second input signal, wherein each of the second plurality of code blocks has a second sequence number associated therewith and is modulated with a second modulation scheme, and wherein the second modulation scheme is different than the first modulation scheme. The multiplexing portion can a third plurality of code blocks based on the first plurality of code blocks, the second plurality of code blocks and planning code block. The planning code block associates each of the third plurality of code blocks with a respective one of the first plurality of code blocks and the second plurality of code blocks.

EP2512054A2 describes a system for a dynamic and flexible multiplexing scheme to allow terminals of a communications system to operate on wideband signals without requiring the operation at full speed, and under multiclass terminal operation. According to the multiplexing scheme, a one codeblock of a plurality of codeblocks within a multiplexed datastream is decoded, wherein each codeblock includes a flag that indicates whether the codeblock contains a timeplan, and the timeplan signifies a multiplexing structure of the datastream. A determination is made as to whether the flag of the one codeblock indicates that the one codeblock contains the timeplan, and, if it is determined that the one codeblock contains the timeplan, the timeplan is acquired. Further, in response to a determination that the one codeblock does not contain the timeplan, a first subsequent codeblock is determined, and decoded. Each codeblock further includes a sequence number indicator that indicates a sequence position of the one codeblock within a first group of the codeblocks of the multiplexed datastream, and the first subsequent codeblock is determined based on one or more of a decode rate of the processor device and the sequence number indicator. A determination is made as to whether the flag of the first subsequent codeblock indicates that the first subsequent codeblock contains the timeplan, and, if it is determined that the first subsequent codeblock contains the timeplan, the timeplan is acquired.

### SUMMARY

The present invention comprises a receiver and a corresponding method as defined by the claims, which define the scope of protection of the invention.

The present disclosure provides, a system and method to increase the efficiency and address the challenges of transmitting high quality video, advanced services via satellite in a cost effective manner while adhering to low power consumption constraints.

In accordance with an aspect of the present disclosure, a transmitter may be provided for use with a first input signal and a second input signal. The transmitter includes a first modulating portion, a second modulating portion and a multiplexing portion. The first modulating portion can output a first plurality of code blocks based on the first input signal, wherein each of the first plurality of code blocks has a first sequence number associated therewith and may be modulated with a first modulation scheme. The second modulating portion can output a second plurality of code blocks based on the second input signal, wherein each of the second plurality of code blocks has a second sequence number associated therewith and may be modulated with a second modulation scheme, and wherein the second modulation scheme may be different than the first modulation scheme. The multiplexing portion can a third plurality of code blocks based on the first plurality of code blocks, the second plurality of code blocks and planning code block. The planning code block associates each of the third plurality of code blocks with a respective one of the first plurality of code blocks and the second plurality of code blocks.

In accordance with another aspect of the present disclosure, a receiver may be provided for use with a third plurality of code blocks based on a first plurality of code blocks, a second plurality of code blocks and planning code block. The first plurality of code blocks may be based on a first input signal. The second plurality of code blocks may be based on a second input signal. Each of the first plurality of code blocks has a first sequence number associated therewith and may be modulated with a first modulation scheme. Each of the second plurality of code blocks has a second sequence number associated therewith and may be modulated with a second modulation scheme. The second modulation scheme may be different than the first modulation scheme. The planning code block associates each of the third plurality of code blocks with a respective one of the first plurality of code blocks and the second plurality of code blocks. The receiver includes a de-multiplexing portion and a recovery portion. The de-multiplexing portion can output a de-multiplexed signal based on the third plurality of code blocks. The recovery portion can output a plurality of received code blocks based on the de-multiplexed signal. Each of the plurality of received code blocks may be modulated with the first modulation scheme. The plurality of received code blocks includes the first plurality of code blocks and the planning code block.

In accordance with another aspect of the present disclosure, a receiver is provided for use with a third plurality of code blocks based on a first plurality of code blocks, a second plurality of code blocks and planning code block. The first plurality of code blocks may be based on a first input signal. The second plurality of code blocks may be based on a second input signal. Each of the first plurality of code blocks has a first sequence number associated therewith and may be modulated with a first modulation scheme. Each of the second plurality of code blocks has a second sequence number associated therewith and may be modulated with a second modulation scheme. The second modulation scheme may be different than the first modulation scheme. The planning code block associates each of the third plurality of code blocks with a respective one of the first plurality of code blocks and the second plurality of code blocks. The receiver includes a recovery portion and a de-multiplexing portion. The recovery portion can output a plurality of received code blocks based on the third plurality of code blocks. The de-multiplexing portion can output a de-multiplexed signal based on the plurality of received code blocks. Each of the plurality of received code blocks may be modulated with the first modulation scheme. The plurality of received code blocks includes the first plurality of code blocks and the planning code block.

Additional advantages and novel features of the disclosure are set forth in part in the description which follows, and in part will become apparent to those skilled in the art upon examination of the following or may be learned by practice of the disclosure. The advantages of the disclosure may be realized and attained by means of the instrumentalities and combinations particularly pointed out in the appended claims.

### BRIEF SUMMARY OF THE DRAWINGS

The accompanying drawings, which are incorporated in and form a part of the specification, illustrate an exemplary embodiment of the present disclosure and, together with the description, serve to explain the principles of the disclosure. In the drawings:
**FIG. 1** illustrates an example conventional transmitter;
**FIG. 2** illustrates an example transmitter in accordance with an aspect of the present disclosure;
**FIG. 3** illustrates an example plurality of data symbols having different modulation schemes and formed into a single codeblock;
**FIG. 4** illustrates an example of individual codeblocks arranged into a TDM codeblock data stream;
**FIG. 5** illustrates an example receiver that ensures faster processing and higher data rates in accordance with an aspect of the present disclosure;
**FIG. 6** illustrates another example receiver that accommodates slow processing and faster data rates in accordance with an aspect of the present disclosure;
**FIG. 7** illustrates an example code division multiplexed codeblock;
**FIG. 8** illustrates another example transmitter using low cost multiplier circuits in accordance with an aspect of the present disclosure;
**FIG. 9** illustrates an example CDM receiver, in accordance with an aspect of the present disclosure;
**FIG. 10** illustrates an example codeblock frame, in accordance with an aspect of the present disclosure;
**FIG. 11** illustrates an example stream in accordance with an aspect of the present disclosure;
**FIG. 12** illustrates an example timeplan in accordance with an aspect of the present disclosure;
**FIG. 13** illustrates an example method of timeplan acquisition in accordance with an aspect of the present disclosure;
**FIG. 14** illustrates another example method of timeplan acquisition in accordance with an aspect of the present disclosure;
**FIG. 15** illustrates another example method of timeplan acquisition in accordance with an aspect of the present disclosure;
**FIG. 16** illustrates an arrangement of a plurality of superframes, in accordance with an aspect of the present disclosure.
**FIG. 17** illustrates an example receiver with a code block selector.
**FIGS. 18a and 18b** illustrate an example of codeblock input and output for a code block selector.
**FIG. 19** illustrates an exemplary look up table that passes every codeblock for processing. **FIG. 20** illustrates exemplary input and output of a code block selector that references a look up table that passes every code block for processing.
**FIG. 21** illustrates an exemplary look up table that passes 2 out of every 4 codeblocks for processing.
**FIG. 22** illustrates exemplary input and output of a code block selector that references a look up table that passes 2 out of every 4 codeblocks for processing.
**FIG. 23** illustrates an example method of operating a code block selector with a look up table.
**FIG. 24** illustrates an example method of synchronizing the code block counter.

### DETAILED DESCRIPTION

In accordance with an aspect of the present disclosure, a plurality of outroute data streams may be multiplexed at the transmitter side, thereby achieving multiple times greater data capacity than existing transmitters. Similarly, a received multiplexed data stream may be demultiplexed at the receiver side in order to achieve greater data capacity.

In an example embodiment, a transmitter has a four outroute streams, multiplexed into one 220 Msps outroute stream. The outroute streams may be multiplexed with either a Time Division Multiplexing (TDM) scheme or a Code Division Multiplexing (CDM) scheme, that can be sent over the satellite system. Before being multiplexed, each outroute stream may be coded with a relatively low rates, for example 55 Msps. Example transmitters in accordance with aspects of the present disclosure will now be described with reference to **FIGs. 2-4****.**

**FIG. 2** illustrates an example transmitter, in accordance with an aspect of the present disclosure.

A transmitter **200** includes a CRO **202,** a CRO **204,** a CRO **206,** a CRO **208,** a modulator **210,** a modulator **212,** a modulator **214,** a modulator **216,** a multiplexer **218,** a match filter **220** and a DAC **222.**

CRO **202** may be arranged to receive an outroute stream signal **224** and output a signal **232.** Modulator **210** may be arranged to output a modulated signal **240** based on signal **232.** In some embodiments, modulator **210** is arranged to receive signal **232** directly from CRO **202.** Similarly, CRO **204** may be arranged to receive an outroute stream signal **226** and output a signal **234.** Modulator **212** may be arranged to output a modulated signal **242** based on signal **234.** In some embodiments, modulator **212** is arranged to receive signal **234** directly from CRO **204.** CRO **206** may be arranged to receive an outroute stream signal **228** and output a signal **236.** Modulator **214** may be arranged to output a modulated signal **244** based on signal **236.** In some embodiments, modulator **214** is arranged to receive signal **236** directly from CRO **206.** CRO **208** may be arranged to receive an outroute stream signal **230** and output a signal **238.** Modulator **216** may be arranged to output a modulated signal **246** based on signal **238.** In some embodiments, modulator **216** is arranged to receive signal **238** directly from CRO **208.**

Multiplexer **218** may be arranged to output a multiplexed signal **248** based on modulated signals **240, 242, 244** and **246.** In some embodiments, multiplexer **218** is arranged to receive modulated signals **240, 242, 244** and **246** directly from modulator **210,** modulator **212,** modulator **214** and modulator **216,** respectively. Match filter **220** may be arranged to output a filtered signal **250** based on multiplexed signal **248.** Non-limiting examples of modulation types supported by filtered signal 250 include TDM and CDM. In some embodiments, match filter **220** is arranged to receive multiplexed signal **248** directly from multiplexer **218.** A match filter, on the transmitter side, is used to limit the bandwidth and reduce adjacent channel interference. On a corresponding receiver side (not shown), a match filter is used as an optimal linear filter for maximizing the signal to noise ratio in the presence of noise. DAC **222** may be arranged to output an analog signal **252** based on filtered signal **250.** In some embodiments, DAC **222 is** arranged to receive filtered signal **250** directly from match filter **220.**

CRO **202,** CRO **204,** CRO **206** and CRO **208** may perform modulation and coding of outroute stream signals **224, 226, 228** and **230,** respectively, and output coded signals **232, 234, 236** and **238,** respectively, in a manner similar to CRO **102** of **FIG. 1****.** Modulators **210, 212, 214** and **216,** receive and encode and bit-to-symbol map coded signals **232, 234, 236** and **238,** respectively, and output modulated signals **240, 242, 244** and **246,** respectively, in a manner similar to modulator **104** of **FIG. 1****.**

Multiplexer **218** multiplexes modulated signals **240, 242, 244** and **246** into one outroute stream as denoted by multiplexed signal **248.** By multiplexing modulated signals **240, 242, 244** and **246** into one outroute stream, transmitter **200** is able to utilize a single device or resource, in this case DAC **222,** to transmit a plurality of signals. Match filter **220** may filter multiplexed signal **248** in order to maximize the signal-to-noise ratio of the transmitted signal, in a similar manner as discussed above with reference to match filter **106** of **FIG. 1****.** DAC **222** may convert transmit filtered signal **250** to analog signal **252.**

Each pair of CRO **202** and modulator **210,** CRO **204** and modulator **212,** CRO **206** and modulator **214,** and CRO **208** and modulator **216** may operate in a similar manner as the pair of CRO **102** and modulator **104** as discussed above with reference to **FIG. 1****.** For purposes of discussion, presume that each pair of CRO **202** and modulator **210,** CRO **204** and modulator **212,** CRO **206** and modulator **214,** and CRO **208** and modulator **216** may operate at a rate of 55 Msps, similar to the conventional transmitter discussed above with reference to **FIG. 1****.**

In contrast with the conventional system discussed above with reference to FIG. 1, in accordance with an aspect of the present disclosure, multiplexer **218** may operate at a much higher rate. For purposes of explanation, presume that in this example embodiment, multiplexer **218,** match filter **220** and DAC **222** may operate at a rate of 220 Msps. The **220** Msps performance of multiplexed signal **248** represents the aggregation of four 55 Msps as denoted by modulated signal **240, 242, 244** and **246.** Multiplexed signal **248** may then be processed via match filter **220** to generate transmit filtered signal **250.** Match filter **220** may operate in a similar manner as match filter **106** as discussed with reference to **FIG. 1****,** however at a significantly increased rate of operation. DAC **222** may convert transmit filtered signal **250** into analog which may then transmitted as analog signal **252.** DAC **222** may operate in a similar manner as DAC **108** as discussed above with reference to **FIG. 1****,** however at a significantly higher rate of operation.

In accordance with a multiplexed arrangement of the present disclosure, a plurality of outroute streams may be modulated, each at a conventional rate. Then the plurality of modulated outroute streams may be multiplexed together, filtered and converted into analog signals at a much higher rate. Accordingly, the overall data throughput provided by a transmitter in accordance with the present disclosure is much greater than that of a conventional transmitter as a result of aggregating multiple conventional information streams into an aggregate information stream performing at a significantly higher rate of operation.

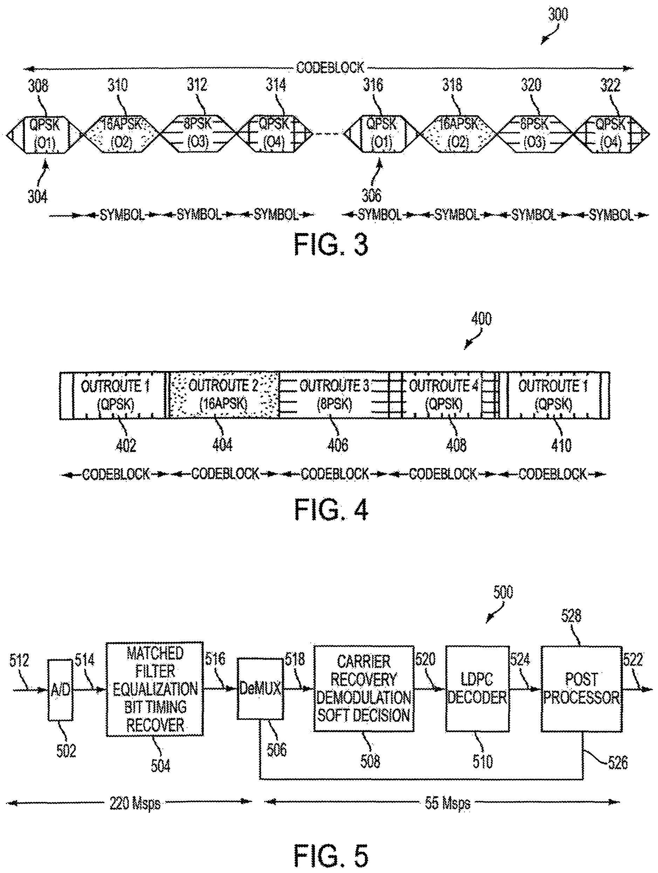

**FIG. 3** illustrates an example codeblock entering into multiplexer **218,** in accordance with an aspect of the present disclosure.

As illustrated in the figure, a codeblock **300** includes a sub-stream **304,** a plurality of additional portions illustrated with a series of dots and a sub-stream **306.** Sub-stream **304** includes a symbol **308,** a symbol **310,** a symbol **312** and a symbol **314.** Sub-stream **306** includes a symbol **316,** a symbol **318,** a symbol **320** and a symbol **322.**

In this example, presume that symbol **308** and symbol **316** correspond to two consecutive symbols within outroute sub-stream signal **224** of **FIG. 2** and have been modulated with a QPSK modulation scheme. In this example, presume that symbol **310** and symbol **318** correspond to two consecutive symbols within outroute sub-stream signal **226** and have been modulated with a 16APSK modulation scheme. In this example, presume that each of symbol **312** and symbol **320** correspond to two consecutive symbols within outroute sub-stream signal **228** and have been modulated with an 8PSK modulation scheme. In this example, presume that each of symbol **314** and symbol **322** correspond to two consecutive symbols within outroute sub-stream signal **230** and have been modulated with a QPSK modulation scheme.

In operation, multiplexer **218** first receives a symbol of modulated signal **240** as symbol **308.** Multiplexer **218** receives a symbol of modulated signal **242** as symbol **310.** Multiplexer **218** then receives a symbol of modulated signal **244** as symbol **312.** Then multiplexer **218** receives a symbol of modulated signal **246** as symbol **314.** Multiplexer **218** continues to receive modulated signals **240, 242, 244** and **246** until codeblock **300** is completely transmitted, ending with the receipt of symbols **316, 318, 320** and **322,** corresponding to modulated signals **240, 242, 244** and **246,** respectively.

**FIG. 4** illustrates an example TDM codeblock data stream **400** leaving multiplexer **218,** in accordance with an aspect of the present disclosure.

As illustrated in **FIG. 4****,** TDM codeblock data stream **400** includes an outroute codeblock **402,** an outroute codeblock **404,** an outroute codeblock **406,** an outroute codeblock **408** and an outroute codeblock **410.**

Outroute codeblocks **402** and **410** are denoted as having been modulated via QPSK. Outroute codeblock **404** is denoted as having been modulated via 16APSK. Outroute codeblock **406** is denoted as having been modulated via 8APSK. Outroute codeblock **408** is denoted as having been modulated via QPSK. It should be noted that an output stream may have a plurality of codeblocks that have been modulated with different types of modulation schemes. For example, although in this example, outroute codeblocks **402** and **410** are each in outroute stream 1 and are denoted as having been modulated via QPSK, in other examples, outroute stream 1 may have outroute codeblocks that have been modulated via other modulation schemes.

In order to reduce complexity, cost and power consumption, a receiver may perform selective reception. For purposes of discussion, presume that four receivers are arranged to receive a signal transmitted from transmitter **200.** For example, a first receiver may receive and reassemble the QPSK codeblock of outroute stream signal **224** of **FIG. 2****,** which correspond to a sampling denoted by example outroute codeblocks **402** and **410** of **FIG. 4****.** The first receiver may ignore the other codeblocks that do not correspond to outroute stream signal **224,** for example a sampling denoted by example outroute codeblocks **404, 406** and **408.** Similarly, a second receiver may receive and reassemble the 16APSK codeblock of outroute stream signal **226** of **FIG. 2****,** which correspond to a sampling denoted by example outroute codeblock **404** of **FIG. 4****.** The second receiver may ignore the other codeblocks that do not correspond to outroute stream signal **226,** for example a sampling denoted by example outroute codeblocks **402, 406, 408** and **410.** Further, a third receiver may receive and reassemble the 8PSK codeblock of outroute stream signal **228** of **FIG. 2****,** which correspond to a sampling denoted by example outroute codeblock **406** of **FIG. 4****.** The third receiver may ignore the other codeblocks that do not correspond to outroute stream signal **228,** for example a sampling denoted by example outroute codeblocks **402, 404, 408** and **410.** Finally, a fourth receiver may receive and reassemble the QPSK codeblock of outroute stream signal **230** of **FIG. 2****,** which correspond to a sampling denoted by example outroute codeblock **408** of **FIG. 4****.** The fourth receiver may ignore the other codeblocks that do not correspond to outroute stream signal **230,** for example a sampling denoted by example outroute codeblocks **402, 404, 406** and **410.**

Again, in accordance with an aspect of the present disclosure, a single transmitter is operable to transmit a single data stream that includes a plurality of outroute codeblocks that have been multiplexed together. A single receiver will be able to receive the entire single data stream. For efficient processing, the receiver will only process a portion of the entire received single data stream. This aspect of the present disclosure will now be described with reference to **FIG. 5****.**

**FIG. 5** illustrates an example receiver, in accordance with an aspect of the present disclosure.

A receiver **500** includes an analog-to-digital converter (ADC) **502,** a match filter equalizer **504,** a de-multiplexer **506,** a demodulator **508,** a low density parity check (LDPC) decoder **510** and a post processor **528.**

ADC **502** may be arranged to receive an analog signal **512** from transmitter **200** and to output a digital signal **514.** Match filter equalizer **504** may be arranged to output a digital signal **516** based on digital signal **514.** In some embodiments, match filter equalizer **504** is arranged to receive digital signal **514** directly from ADC **502.** De-multiplexer **506** may be arranged to output a de-multiplexed signal stream **518** based on digital signal **516** and a data signal **526.** In some embodiments, de-multiplexer **506** is arranged to receive digital signal **516** directly from match filter equalizer **504.** In some embodiments, de-multiplexer **506** is arranged to receive data signal **526** directly from post processor **528.** Demodulator **508** may be arranged to output a demodulated signal **520** based on de-multiplexed signal stream **518.** In some embodiments, demodulator **508** is arranged to receive de-multiplexed signal stream **518** directly **from** de-multiplexer **506.** LDPC decoder **510** may be arranged to output a decoded signal **524** based on demodulated signal **520.** In some embodiments, LDPC decoder **510** is arranged to receive demodulated signal **520** directly from demodulator **508.** Post processor **528** may be arranged to output a data signal **522** and data signal **526,** each based on decoded signal **524.** In an example embodiment, post processor **528** is arranged to receive decoded signal **524** directly from LDPC decoder **510.**

ADC **502** converts received analog signals transmitted from an analog format to a digital format. Match filter equalizer **504** performs matched filtering of digital signal **514 in** order to maximize the signal-to-noise ratio of the received signal. Furthermore, match filter equalizer **504** may perform recovery of bit timing. De-multiplexer **506** may select the portions of the received signal for processing. Demodulator **508** performs demodulation of the symbols selected by de-multiplexer **506** to form a reassembled codeblock. LDPC decoder **510** may decode of the received signal. Post processor **528** may provide timeplan information to de-multiplexer **506** such that de-multiplexer **506** may select the correct codeblocks for delivery to demodulator **508.** The timeplan information will be described in greater detail below.

In operation, receiver **500** receives analog signal **512.** After ADC **502** converts analog signal **512** to digital signal **514,** match filter equalizer **504** filters digital signal **514** to maximize the signal-to-noise ratio and thus improve signal quality. Match filter equalizer **504** may also operate to perform bit timing recovery in order to determine the starting and ending times for received symbols. De-multiplexer **506** then selects the portions of digital signal **516** for processing. For example, as described with reference to **FIG. 3** and **FIG. 4****,** de-multiplexer **506** may select to pass symbol **308** and symbol **316** via digital signal **516** and reject other symbols. Demodulator **508** performs demodulation of the symbols selected by de-multiplexer **506** to form a reassembled codeblock. For example, as described with reference to **FIG. 3** and **FIG. 4****,** a multiplicity of symbols with a sampling denoted as symbol **308** and symbol **316** may be reassembled to form the codeblock denoted as outroute codeblock **402.** De-multiplexed signal stream may then be processed into original streams delivered to LDPC decoder **510** for decoding. LDPC codes may be defined as Low Density Parity Codes and having an easily parallelizable decoding algorithm, performing simple arithmetic operations suitable for iterative decoding. Post processor **528** may receive the digitized, filtered, de-multiplexed, demodulated, reassembled and decoded signal for error detection and timeplan management.

As will be described in more detail below, analog signal **512** will include a timeplan indicating which codeblocks receiver **500** should decode. Post processor **528** will use this information to instruct de-multiplexer **506** as to which portions of digital signal **516** to pass for processing.

In order to reduce complexity, cost and power consumption, receiver **500** may perform selective reception. For purposes of discussion, presume that receiver **500** is intended to receive and reassemble the 16APSK symbols of outroute stream signal **226** of **FIG. 2****,** which correspond to a sampling denoted by example outroute codeblock **404** of **FIG. 4****.** Receiver **500** may ignore the other symbols that do not correspond to outroute stream signal **226,** for example a sampling denoted by example outroute codeblocks **402, 406, 408** and **410.**

In accordance with a multiplexed arrangement of the present disclosure, a single received stream that includes a plurality of outroute streams may be demultiplexed at a very high rate. Then the single batch of codeblocks selected by the multiplexer may be demodulated, decoded and processed at a much lower rate. Accordingly, the overall data processed by a receiver in accordance with the present disclosure may be similar to that of a conventional transmitter even though the received signal is received at a significantly higher rate. In other words, in accordance with an aspect of the present disclosure, a single transmitter is operable to transmit a single data stream that includes a plurality of outroute codeblocks that have been multiplexed together. Receiver **500** will be able to receive the entire single data stream. For efficient processing, receiver **500** will only process a portion of the entire received single data stream.

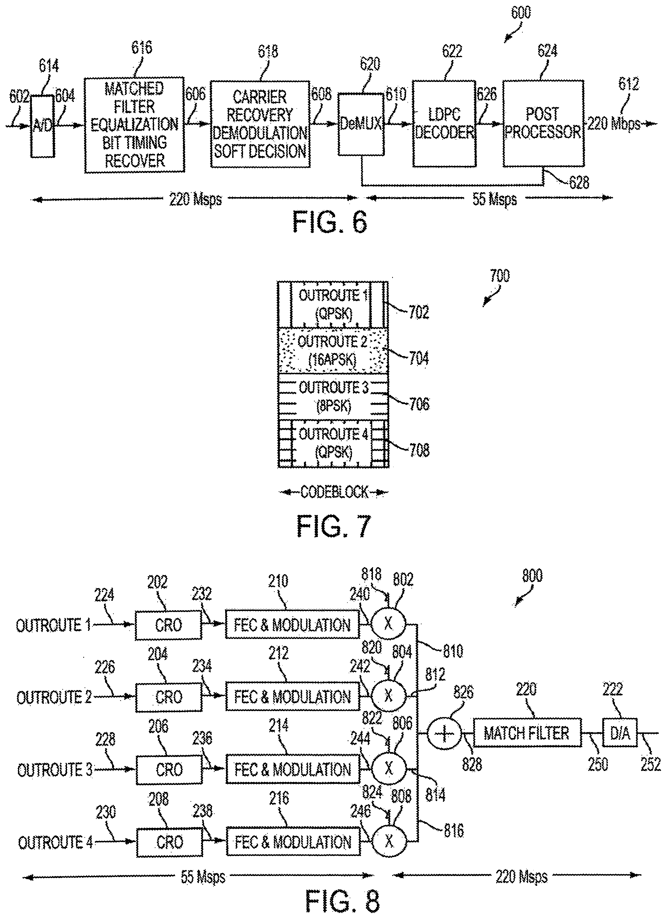

In the example embodiment discussed above with reference to **FIG. 5****,** a received signal is de-multiplexed and is then demodulated. However, in other embodiments, a received signal may first be demodulated and then de-multiplexed. This will now be described in greater detail below with reference to **FIG. 6****.**

**FIG. 6** illustrates an example receiver with carrier recovery performed prior to the de-multiplexer in accordance with an aspect of the present disclosure.

As illustrated in the figures, a receiver **600** includes an ADC **614,** a match filter equalizer **616,** a demodulator **618,** a de-multiplexer **620,** a LDPC decoder **622** and a post processor **624.**

ADC **614** may be arranged to receive an analog signal **602** from satellite transmitter **200** and to output a digital signal **604.** Match filter equalizer **616** is arranged output a recovered signal **606** based on digital signal **604.** In some embodiments, match filter equalizer **616** is arranged to receive digital signal **604** directly from ADC **614.** Demodulator **618** is arranged to output a demodulated signal **608** based on recovered signal **606.** In some embodiments, demodulator **618 is** arranged to receive recovered signal **606** directly from match filter equalizer **616.** De-multiplexer **620** may be arranged to output a de-multiplexed signal stream **610** based on demodulated signal **608** and a feedback signal **628.** In some embodiments, de-multiplexer **620** is arranged to receive demodulated signal **608** directly from demodulator **618.** In some embodiment, de-multiplexer **620** is arranged to receive feedback signal **628** directly from post processor **624.** LDPC decoder **622** may be arranged to output a decoded data signal **626** based on de-multiplexed signal stream **610.** In some embodiments, LDPC decoder **622** is arranged to receive de-multiplexed signal stream **610** directly from de-multiplexer **620.** Post processor **624** may be arranged to output a data signal **612** based on decoded data signal **626** and also to deliver timeplan information via feedback signal **628** based on decoded data signal **626.** In some embodiments, post processor **624** is arranged to receive decoded data signal **626** directly from LDPC decoder **622.**

ADC **614** may convert received analog signals transmitted from a satellite to digital format for further processing in a similar manner to ADC **502** as discussed above with reference to **FIG. 5****.** Match filter equalizer **616** may filter digital signal **604** in order to maximize the signal-to-noise ratio of the received signal. Furthermore, match filter equalizer **616** may perform bit timing recovery. Match filter equalizer **616** may operate in a similar manner as match filter equalizer **504** as discussed above with reference to **FIG. 5****.** Demodulator **618** may perform demodulation of recovered signal **606** and may operate in a similar manner as demodulator **508** as discussed above with reference to **FIG. 5****,** except demodulator **618** may operate as a significantly higher rate than demodulator **508.** De-multiplexer **620** may recover the carrier signal and reassemble the digitized, filtered and demodulated received signal into the recovered de-multiplexed signal stream **610.** Furthermore, de-multiplexer **620** may operate in a similar manner to de-multiplexer **506** as discussed above with reference to **FIG. 5****.** LDPC decoder **622** performs decoding for recovery of the originally transmitted information, with exception for performing error detection/correction. LDPC decoder **622** may operate in a similar manner to LDPC decoder **510** as discussed above with reference to **FIG. 5****.** Post processor **624** may perform error detection and for generating timeplan information for delivery to De-multiplexer **620.** Post processor **624** may operate in a similar manner to post processor **528** as discussed above with reference to **FIG. 5****.**

A difference between the embodiment discussed above with reference to **FIG. 5** and the embodiment discussed above with reference to **FIG.6** is the placement of the de-multiplexer with respect to the demodulator. In the embodiment discussed above with reference **FIG. 5****,** de-multiplexer **506** is arranged prior to demodulator **508.** On the other hand, in the embodiment discussed above with reference to **FIG. 6****,** de-multiplexer **620** is arranged after demodulator **618.**

Compared to receiver **500,** receiver **600** in operation may require greater complexity, power consumption and processor utilization, and as a result, a higher cost.

As described with reference to **FIGs. 3-6****,** a plurality of streams of information may be assembled and transmitted at a high rate from a single transmitter to a plurality of receivers. The information destined for a single receiver may be a portion of the information as transmitted by the transmitter. The assembly of the transmitted information and the configuration of the receiver enable a portion of the receiver to operate at a reduced rate, with an overall lower power consumption and cost.

The examples as discussed above with reference to **FIGs. 3-6** were performed based upon time division multiplexing. However, in accordance with another aspect of the present disclosure, other types of multiplexing may be used. For example, a transmitter and receiver may be configured where the multiplexing scheme may be based upon code division multiplexing (CDM). CDM employs a special coding scheme, wherein each receiver is assigned a code, to allow multiple users to be multiplexed over the same physical channel. An embodiment using CDM will now be discussed with reference to **FIG. 7****.**

**FIG. 7** illustrates an example CDM codeblock **700.**

As illustrated in the figure, CDM codeblock **700** includes an outroute **702,** an outroute **704,** an outroute **706** and an outroute **708.**

Outroute **702** may be a QPSK modulated bit stream packet and configured as a portion of CDM codeblock **700.** Outroute **704** may be a 16APSK modulated bit stream packet and configured as a portion of CDM codeblock **700.** Outroute **706** may be an 8PSK modulated bit stream packet and configured as a portion of CDM codeblock **700.** Outroute **708** may be a QPSK modulated bit stream packet and configured as a portion of CDM codeblock **700.**

Outroutes **702, 704, 706** and **708** may be transmitted simultaneously via a single channel. A bit of information to be transmitted may be translated into a code represented by a multiplicity of bits. The outroutes may have differing and orthogonal codes. The translated orthogonal codes for the various outroutes allows for discrimination between the codes by a receiver or receivers.

In operation, individual outroute data streams may be modulated utilizing CDM scheme. Modulated CDM codeblock **700,** an aggregate of outroutes **702, 704, 706** and **708,** may be processed from outroute stream signals **224, 226, 228** and **230.**

**FIG. 8** illustrates an example transmitter performing transmission of codeblocks via CDM modulation as described with reference to the **FIG. 7****,** in accordance with an aspect of the present disclosure,.

A transmitter **800** includes CRO **202,** CRO **204,** CRO **206,** CRO **208,** modulator **210,** modulator **212,** modulator **214,** modulator **216,** match filter **220,** DAC **222,** a multiplier **802,** a multiplier **804,** a multiplier **806, a** multiplier **808** and an adder **826.**

CRO **202** may be arranged to receive outroute stream signal **224** and output signal **232.** Modulator **210** may be arranged to output modulated signal **240** based on signal **232.** In some embodiments, modulator **210** is arranged to receive signal **232** directly from CRO **202.** Similarly, CRO **204** may be arranged to receive outroute stream signal **226** and output signal **234.** Modulator **212** may be arranged to output modulated signal **242** based on signal **234.** In some embodiments, modulator **212** is arranged to receive signal **234** directly from CRO **204.** CRO **206** may be arranged to receive outroute stream signal **228** and output signal **236.** Modulator **214** may be arranged to output modulated signal **244** based on signal **236.** In some embodiments, modulator **214** is arranged to receive signal **236** directly from CRO **206.** CRO **208** may be arranged to receive outroute stream signal **230** and output signal **238.** Modulator **216** may be arranged to output modulated signal **246** based on signal **238.** In some embodiments, modulator **216** is arranged to receive signal **238** directly from CRO **208.**

Multiplier **802** is arranged to output a code multiplied signal **810** based on a code **818** and modulated signal **240.** In some embodiments, multiplier **802** is arranged to receive modulated signal **240** directly from modulator **210.** Multiplier **804** is arranged to output a code multiplied signal **812** based on a code **820** and modulated signal **242.** In some embodiments, multiplier **804** is arranged to receive modulated signal **242** directly from modulator **212.** Multiplier **806** is arranged to output a code multiplied signal **814** based on a code **822** and modulated signal **244.** In some embodiments, multiplier **806** is arranged to receive modulated signal **244** directly from modulator **214.** Multiplier **808** is arranged to output a code multiplied signal **816** based on a code **824** and modulated signal **246.** In some embodiments, multiplier **808** is arranged to receive modulated signal **246** directly from modulator **216.**

Adder **826** may be arranged to output a CDM signal **828** based on code multiplied signals **810, 812, 814** and **816.** In some embodiments, adder **826** is arranged to receive code multiplied signal **810** directly from multiplier **802.** In some embodiments, adder **826 is** arranged to receive code multiplied signal **812** directly from multiplier **804.** In some embodiments, adder **826** is arranged to receive code multiplied signal **814** directly from multiplier **806.** In some embodiments, adder **826** is arranged to receive code multiplied signal **816** directly from multiplier **808.**

Match filter **220** may be arranged output filtered signal **250** based on CDM signal **828.** In some embodiments, match filter **220** is arranged to receive CDM signal **828** directly from adder **826.** DAC **222** may be arranged to output analog signal **252** based on filtered signal **250.** In some embodiments, DAC **222** is arranged to receive filtered signal **250** directly from match filter **220.**

CRO **202, 204, 206** and **208** may operate in a similar manner as discussed above with reference to **FIG. 2****.** Modulators **210, 212, 214** and **216,** perform modulation and forward error correction coding for input coded signals **232, 234, 236** and **238,** respectively and output corresponding corrected modulated signals **240, 242, 244** and **246** in a similar manner as discussed above with reference to **FIG. 2****.**

Multipliers **802, 804,806** and **808** may be configured as code multipliers, performing multiplication of input signals with specific codes and delivering corresponding code multiplied signals **810, 812, 814** and **816.** For example, multiplier **802** will multiply modulated signal **240** with code **818** to generate code multiplied signal **810.** Accordingly, a receiver (not shown) that is intended to receive modulated signal **240** will recognize the code **818** aspect of code multiplied signal **810.** The receiver that is intended to receive modulated signal **240** will then be able to demodulate and process the information within code multiplied signal **810,** while ignoring code multiplied signals **812, 814** and **816.** Similarly, another receiver that is intended to receive modulated signal **242** will be able to demodulate and process the information within code multiplied signal **812,** while ignoring code multiplied signals **810, 814** and **816.** Further, yet another receiver that is intended to receive modulated signal **244** will be able to demodulate and process the information within code multiplied signal **814,** while ignoring code multiplied signals **810, 812,** and **816.** Finally, still another receiver that is intended to receive modulated signal **246** will be able to demodulate and process the information within code multiplied signal **816,** while ignoring code multiplied signals **810, 812** and **814.**

Adder **826** may perform a summation of input code multiplied signals **810, 812, 814** and **816** and output a single stream of CDM signal **828.**

Match filter **220** may perform filtering in order to maximize the signal-to-noise ratio of input CDM signal **828** and output filtered signal **250.** Match filter **220** may operate in a similar manner as discussed above with reference to **FIG. 2****.** DAC **222** may convert filtered signal **250** to analog signal **252** in a similar manner as discussed above with reference to **FIG. 2****.**

In this non-limiting example, four CROs may accept four outroute streams as discussed with reference to **FIG. 2****.** However, it should be noted that any number of CROs may be used to a corresponding number of outroute streams.

In accordance with a multiplexed arrangement of the present disclosure, a plurality of outroute streams may be modulated, each at a conventional rate. Then the plurality of modulated outroute streams may be added together, filtered and converted into analog signals at a much higher rate. Accordingly, the overall data throughput provided by a CDM transmitter in accordance with the present disclosure is much greater than that of a conventional CDM transmitter as a result of aggregating multiple conventional information streams into an aggregate information stream performing at a significantly higher rate of operation.

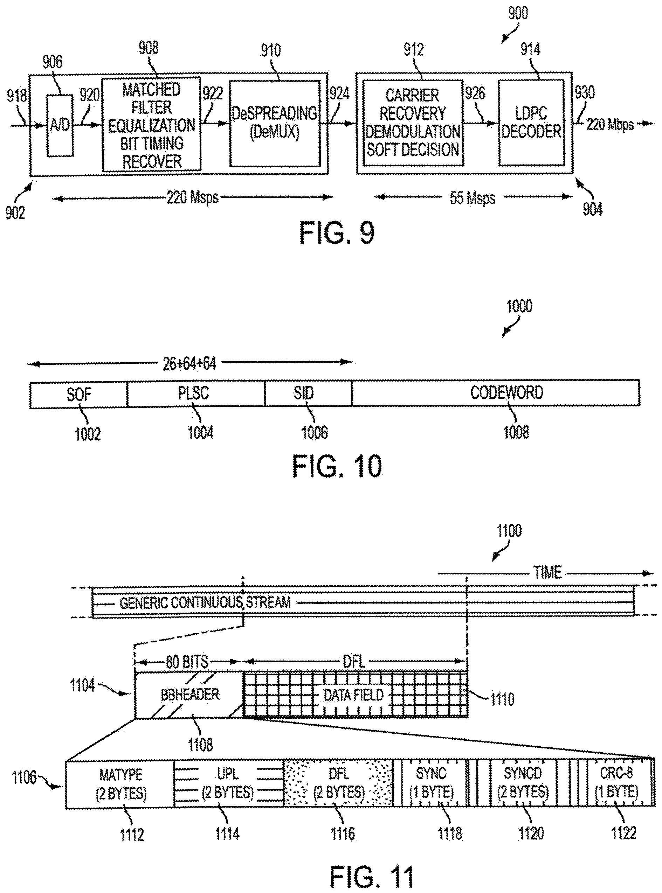

Again, in accordance with an aspect of the present disclosure, a single transmitter is operable to transmit a single data stream that includes a plurality of outroute codeblocks that have been multiplexed and added together. A single receiver will be able to receive the entire single data stream. For efficient processing, the receiver will only process a portion of the entire received single data stream. This aspect of the present disclosure will now be described with reference to **FIG. 9****.**

**FIG. 9** illustrates an example CDM receiver, in accordance with an aspect of the present disclosure.

A CDM receiver **900** includes a faster operational portion **902** and a slower operational portion **904.**

CDM receiver **900** may receive and process a CDM modulated signal and deliver a recovered signal. Non-limiting examples of processing includes ADC, matched filter equalization, bit timing recovery, de-spreading, carrier recovery, demodulation, soft decision, LDPC decoding and post processing. CDM receiver **900** may receive and process signals as described with reference to **FIG. 7** and as transmitted by receiver **800** as described with reference to **FIG. 8****.**

Faster operational portion **902** may receive and process a CDM modulated signal and deliver a de-spreaded signal. Slower operational portion **904** may receive a de-spreaded signal from faster operational portion **902** and deliver a recovered signal.

Faster operational portion **902** includes an ADC **906,** a filter **908** and a de-multiplexer 910.

ADC **906** may receive an analog signal **918** and output a digitized signal **920.** Filter **908** is arranged to output a filtered signal **922** based on digitized signal **920.** In some embodiments, filter **908** is arranged to receive digitized signal **920** directly from ADC **906.** De-multiplexer **910** is arranged to output a de-spreaded signal **924** based on filtered signal **922.** In some embodiments, de-multiplexer **910** is arranged to receive filtered signal **922** directly from filter **908.**

ADC **906** may perform conversion of a received analog signal **918** to digitized signal **920.** ADC **906** may operate in a similar manner as ADC **502** discussed above with reference to **FIG. 5****.**

Filter **908** may process digitized signal **920** received from ADC **906.** Non-limiting examples of processing performed by filter **908** include matched filtering, equalization and bit timing recovery. Filter **908** may optimize the signal-to-noise ratio of a received signal.

De-multiplexer **910** may perform de-spreading of received filtered signal **922** and deliver de-spreaded signal **924.**

Slower operational portion **904** includes a demodulator **912** and a LDPC decoder **914.**

Demodulator **912** is arranged to output a signal **926** based de-spreaded signal **924.** In some embodiments, demodulator **912** is arranged to receive de-spreaded signal **924** directly from de-multiplexer **910.** LDPC decoder **914** is arranged to output a recovered signal **930** based on demodulated signal **926.** In some embodiments, LDPC decoder **914** is arranged to receive demodulated signal **926** directly from demodulator **912.**

Demodulator **912** may process de-spreaded signal **924** received from de-multiplexer **910** and deliver demodulated signal **926.** Non-limiting examples of processing performed by demodulator **912** include carrier recovery, demodulation and soft decision.

LDPC decoder **914** may receive demodulated signal **926** from demodulator **912** and perform LDPC decoding. LDPC decoder **914** may operate in a similar manner to LDPC decoder **510** as discussed above with reference to **FIG. 5****.**

CDM receiver **900** may receive analog signal **918** encoded and modulated as described with reference to example CDM codeblock **700** of **FIG. 7****.** Analog signal **918** may be processed at a faster operational speed by faster operational portion **902.** Faster operational portion **902** may deliver a digitized, filtered and de-spread signal denoted as de-spreaded signal **924.** Slower operational portion **904** may receive de-spreaded signal **924** and perform demodulation and decoding of de-spreaded signal **924** for delivery of recovered information via recovered signal **930.** Outroute **702** may illustrate an example of recovered information.

For purposes of discussion, presume that analog signal **918** corresponds to the combination of outroutes **702, 704, 706** and **708,** which corresponds to analog signal **252** as provided by transmitter **800.** Further, presume that CDM receiver **900** is configured to retrieve data within outroute stream signal **226,** which in this example corresponds to outroute **704.** In this example, the processing of analog signal **918** is performed at an increased rate by faster operational portion **902.** Now, presume that de-spreaded signal **924** corresponds to modulated signal **242** and presume that modulated signal **242** corresponds to outroute **704.** In such a case, slower operational portion **904** only be required to demodulate and decode the portions of analog signal **252** that corresponds to modulated signal **242.** Therefore, slower operational portion **904** may operate at a reduced rate. Furthermore, operation at a reduced rate reduces cost, complexity, semiconductor real-estate and power consumption.

**FIG. 10** illustrates an example codeblock frame **1000,** in accordance with an aspect of the present disclosure.

A codeblock frame **1000** includes, a start of frame (SOF) **1002,** a physical layer signaling code (PLSC) **1004,** a stream identifier (SID) **1006** and a codeword **1008.**

SOF **1002** may be arranged at the beginning of the example codeblock frame **1000.** PLSC **1004** may be arranged to follow SOF **1002** in the frame structure of example codeblock frame **1000.** SID **1006** may be to follow PLSC **1004** and prior to codeword **1008** in example codeblock frame **1000.** Codeword **1008** may be arranged at the end of example codeblock frame **1000.**

SOF **1002** may be configured as a 26 bit sub-frame for identifying a start of the frame. PLSC **1004** may be configured as a 64 bit sub-frame for performance of physical layer signal coding. The coding may be a portion of example codeblock frame **1000** and may be transmitted or received during communication between a transmitter and a receiver. SID **1006** may be configured as a 64 bit Stream identifier for identifying a stream at a receiving station. SID **1006** may be intended to be received by a station that receives frames corresponding to a SID match. SID **1006** may also inform the receiver what the modulation scheme of the codeblock. Codeword **1008** contains the original information, wherein the information are coded bits.

In operation, outroute signals, described with reference to **FIG. 2****,** may be formed into a frame structure with building blocks SOF **1002,** PLSC **1004,** SID **1006** and codeword **1008.** A codeblock may be configured as a first level framing structure containing synchronization and signaling information as described with reference to **FIG. 4** and **FIG. 7****.**

In accordance with an aspect of the present disclosure, an example stream format for a generic continuous stream will now be described in greater detail with reference to **FIG. 11****.** Generic Stream Encapsulation (GSE) protocol may enable efficient encapsulation of internet protocol (IP) and other network layer packets over a generic physical layer. Encapsulated data may be transported over GSE packet streams. GSE encapsulation relies on the physical layer being able to perform error detection.

**FIG. 11** illustrates an example stream in accordance with an aspect of the present disclosure.

A stream **1100** includes a multiplicity of main frames with a sampling denoted as a frame **1104.**

Stream **1100** may be used for communication between a transmitter and a receiver (e.g. transmitter **200** of **FIG. 2****,** receiver **500** of **FIG. 5****,** receiver **600** of **FIG. 6****,** transmitter **800** of **FIG. 8** and CDM receiver **900** of **FIG. 9****.**

Frame **1104** includes a sub frame base band header (BBHEADER) **1108** and a data field (DATAFIELD) **1110.** BBHEADER **1108** includes a subframe **1106** that may be subdivided further into smaller frames, a transport stream input (MATYPE) **1112,** a user packet length (UPL) **1114,** a data field length (DFL) **1116,** a synchronization bit (SYNC) **1118,** a distance from the beginning of a datafield (SYNCD) **1120** and a cyclic redundancy check bit (CRC-8) **1122.**

BBHEADER **1108** and DATAFIELD **1110** may be arranged within stream **1100.** MATYPE **1112,** UPL **1114,** DFL **1116,** SYNC **1118,** SYNCD **1120** and CRC-8 may be arranged within BBHEADER **1108.**

Stream **1100** may be configured as an outroute stream with a multiplicity of codeblocks multiplexed into a single stream using either TDM or CDM multiplexing methods. Frame **1104** may be configured as a packet format within stream **1100** delivering BBHEADER **1108** and DATAFIELD **1110.** MATYPE **1112** may be configured as a portion of subframe **1106,** a 2-byte packet operating as a transport stream input. UPL **1114** may be configured as a portion of subframe **1106,** a 2-byte packet functioning as a user packet length for stream **1100.**

DFL **1116** may be arranged within BBHEADER **1108.** DFL **1116** may provide user data field length and prevent the packet from becoming fragmented during the transport process. SYNC **1118** may be arranged within BBHEADER **1108.** SYNC **1118** may provide a synchronization bit to BBHEADER **1108** for providing frame synchronization. SYNCD **1120** may be arranged within BBHEADER **1108.** SYNCD may provide a value indicating distance in bits from the beginning of DATAFIELD **1110** to the end DATAFIELD **1110.** CRC-8 **1122** may be arranged within BBHEADER **1108.** CRC-8 **1122** may provide an error detection code applied to the first 9 bytes of BBHEADER **1108.**

In operation, stream **1100** includes a multiplicity of frame **1104** with a variable length. Encapsulated IP packet data may be transported using GSE streams. Each GSE packet may be composed of GSE header followed by GSE payload reference as DATAFIELD **1110.** BBHEADER **1108** may be composed of MAYTYPE, UPL, DFL, SYNC SYNCD and CRC-8 as described with reference to **FIG. 11****.**

Variable lengths for frame **1104** may prevent information from being transported via packets and, as a result, some of the unused bits in BBHEADER **1108** may be used for de-multiplexing codeblocks.

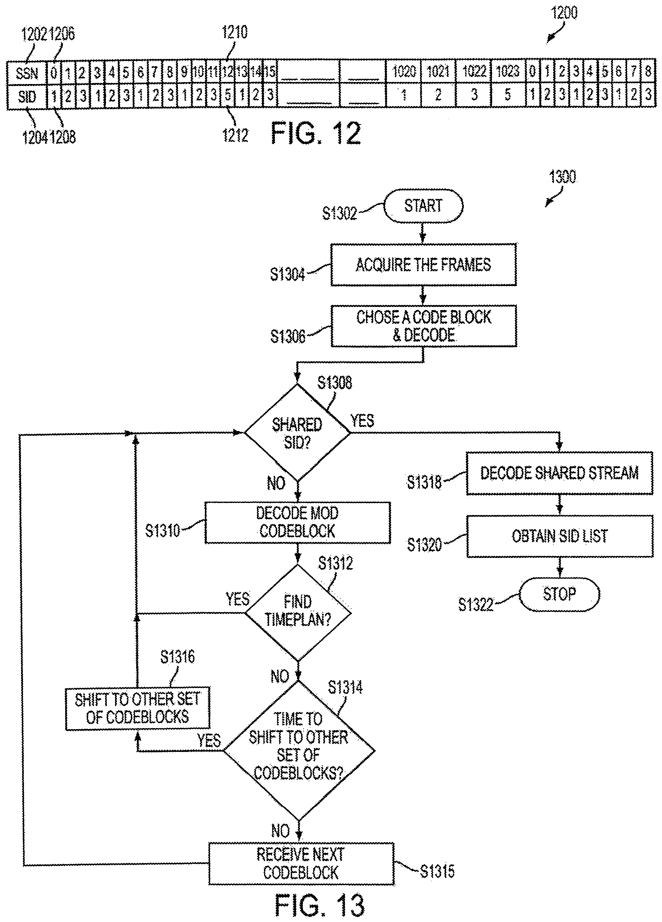

In accordance with an aspect of the present disclosure, a receiver may determine which codeblocks should be demodulated and decoded from the entire received stream of codeblocks based on a timeplan. The timeplan indicates the positions of codeblocks within the stream of codeblocks. This will be described in greater detail with reference to **FIG. 12****.**

**FIG. 12** illustrates an example timeplan in accordance with an aspect of the present disclosure.

A timeplan **1200** includes a stream sequence number (SSN) **1202** and a stream identifier SID **1204.**

An element of SSN **1202** may be arranged with a corresponding SID **1204** within timeplan **1200.**

Timeplan **1200** may be communicated via a codeblock, for example outroute codeblock **402 (****FIG. 4****).** The codeblock location for transmission of timeplan **1200** may repeatedly be transmitted via the same codeblock, for example outroute codeblock **402 (****FIG. 4****).**

In an example embodiment, SSN **1202** may be configured as a 10-bit counter from 0 to 1023 within timeplan **1200** for assigning sequence number to codeblocks. SID **1204** may be configured for indicating a portion of a stream for reception by a receiving terminal and a portion of a stream for reception by the universe of receiving terminals.

An outroute is a combination of substreams. Accordingly, a timeplan is transmitted for every outroute. In this example, timeplan **1200** may be transmitted for every outroute, with potentially different outroutes being transmitted in a single channel. Furthermore, in an example embodiment, timeplan **1200** may be transmitted once every **1024** codeblocks.

In operation, timeplan **1200** may be configured as a sequence of SSN **1202** with a corresponding SID **1204** and may be broadcast to all receivers within a system. For purposes of discussion, presume that transmitter **200** of **FIG. 2** transmits analog signal **252** to four different receivers, wherein the four different receivers are constructed so as to demodulate and process one of outroute stream signal **224,** outroute stream signal **226,** outroute stream signal **228** and outroute stream signal **230** respectively. In such a case, each of the four receivers will receive the entire analog signal **252,** which includes timeplan **1200.**

Furthermore, a receiver attempting to acquire information via an outroute carrier would receive timeplan **1200** within a predetermined period of time. A receiver may receive and decode timeplan **1200** to determine which portions of a codeblock are associated with the receiver. At that point, the receiver would then decode the stream that carries the SID and SSN information. Reception and decoding of timeplan **1200** by a receiver may occur periodically as necessary. Following reception of an initial timeplan **1200,** a determination of operating on a different outroute may be realized, after which a receiver may switch to the correct outroute. Following a switch to a new outroute, a receiver may receive and decode a new timeplan **1200** corresponding to the new outroute.

For example, a sequence number **1206** may have a value of "0," indicating the first transmission for SSN **1202** and SID **1204.** Furthermore, an identifier **1208** may have a value of "1," indicating the first portion of a codeblock may be received by receiver "1." Similarly, a sequence number **1210** may have a value of "12" indicating the twelfth transmission for SSN **1202** and SID **1204.** Further, an identifier **1212** may have a value of "S" indicating that the twelfth portion of a codeblock may be received by the universe of receivers.

**FIG. 13** illustrates an example method for timeplan acquisition, in accordance with an aspect of the present disclosure.

A method **1300** starts **(S1302)** and the frames may be acquired **(S1304).**

Receiver **500** of **FIG. 5****,** receiver **600** of **FIG. 6** or CDM receiver **900** of **FIG. 9** may begin receiving a stream of information as denoted by stream **1100** of **FIG. 11****.** For purposes of simplifying the discussion, presume that receiver **500** is used. Furthermore, receiver **500** may perform frame synchronization for determining the start of frame **1104.** Still further, receiver **500** may receive and process received frames (e.g. frame **1104**).

Receiver **500** may then select a codeblock for processing **(S1306).** For purposes of discussion, presume that receiver **500** selects the first codeblock for processing. The selection of codeblock to process may be performed via de-multiplexer **506.**

It may then be determined whether the selected codeblock has a shared SID "S" **(S1308).** For example, SID **1006** of **FIG. 10** may be decoded by post processor **528.** Decoded SID **1006** may indicate whether the received information may be communicated to a particular receiver as illustrated by identifier **1208** of **FIG. 12** or the universe of terminals as illustrated by identifier **1212.**

If it is determined that the selected codeblock does not have a shared SID **(S1308),** then the receiver may receive and decode a codeblock from a different portion of frame **1104** of **FIG. 11** **(S1310).** For example, receiver **500** may then select another codeblock for processing.

At this point it may be determined whether the newly selected codeblock includes a timeplan **(S1312).** If so, then it is again determined whether the newly selected codeblock has a shared SID **(S1308).**

If the selected codeblock does not include a timeplan **(S1312),** then a determination for shifting to an alternate set of codeblocks may be determined **(S1314).** For example, once receiver **500** has received and decoded a timeplan, receiver **500** may determine the proper codeblocks to receive and process.

If it is determined that it is not time to shift to an alternate set of codeblocks, then another codeblock may be received **(S1315)** followed by a determination of shared SID **(S1308).** In an example embodiment, a first set of codeblocks may have even SSN, whereas the other set may have odd SSN. If the shared SID is not found in the first set of codeblocks, it will be found in the next set of codeblocks.

If it is determined that it is time to switch to an alternate set of codeblocks **(S1314),** then the sequence of codeblocks may be switched to the alternate set and a codeblock from the alternate set may be received **(S1316)** followed by a determination of shared SID **(S1308).**

Once it is determined that there is a shared SID **(S1308),** the shared stream may be decoded **(S1318).** At that point, the SID list may be generated **(S1320).** A shared SID contains information to be shared by all substreams. One type of shared information that may be in a shared SID is the timeplan. In an example embodiment, a timeplan is transmitted once in a superframe having 1024 codeblocks, many of which may be shared SIDs. As such, when the SID list is generated, the shared SIDs are searched for the timeplan. Receiver **500** may determine portions of the codeblock associated with receiver **500** as described with reference to **FIG. 2****.** For example, presume for the sake of discussion that receiver **500** corresponds to SID 1 within timeplan **1200** of **FIG. 12****.** Accordingly, receiver **500** would then decode SSNs having an SID 1 associated therewith. Returning to **FIG. 5****,** post processor **528** would then instruct de-multiplexer **506,** via data signal **526,** to only pass the codeblocks corresponding to the SSNs associated with the SID 1 of timeplan **1200.**

Once a receiver has determined portions associated with receiver, execution of method **1300** may terminate **(S1322).**

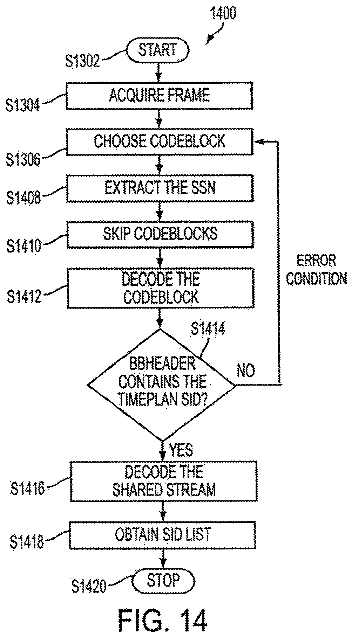

**FIG. 14** illustrates an example method **1400** of timeplan acquisition in accordance with an aspect of the present disclosure. This method presents a simplified method for timeplan acquisition requiring less processing for timeplan acquisition as compared to method **1300.**

The beginning of method **1400** is similar to method **1300** discussed above with reference to **FIG. 13****.** In particular method **1400** starts **(S1302),** frames are acquired **(S1304)** and a codeblock is selected **(S1306).**

At this point method **1400** differs from method **1300.** Here, SSN may be extracted from the selected codeblock **(S1408).** The SSN, for example as described with reference to **FIG. 12****,** may be extracted for processing.

Based upon on SSN received, the receiver may skip codeblocks **(S1410).** For example, the receiver may determine the number of codeblocks to skip to access the desired codeblock based upon the received SSN. At this point the SID list would be obtained.

It is then determined whether the accessed codeblock has a shared SID **(S1414).** For example, for purposes of discussion, presume that SID **1006** of **FIG. 10** is decoded. Decoded SID **1006** may indicate whether the received information may be communicated to a particular receiver (for example as illustrated by identifier **1208** of **FIG. 12****)** or to all the receivers (for example as illustrated by identifier **1212**).

If it is determined that the accessed codeblock does not have a shared SID, then a new codeblock is chosen **(S1306).** Alternatively, if it is determined that the accessed codeblock does have a shared SID, **then** the shared stream may be decoded **(S1416).** Once a receiver has received a timeplan and found a correct channel, shared information stream may be received and decoded.

At that point the SID list is obtained from the timeplan **(S1418).** For example, the receiver may determine portions of codeblock associated with itself, as described with reference to **FIG. 2****.**

Once a receiver has determined portions associated with receiver, method **1400** stops **(S1420).**

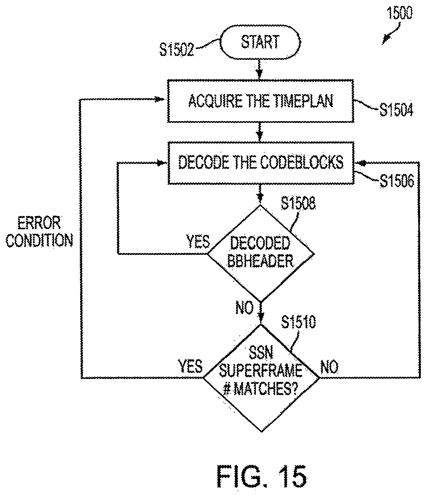

**FIG. 15** illustrates an example method of timeplan acquisition following powering up of a receiver, in accordance with an aspect of the present disclosure.

A method **1500** starts **(S1502)** and timeplan **1200** of **FIG. 12** may be acquired.

Following powering up of a receiver, timeplan **1200** may be acquired in a similar manner as discussed above with referenced to **FIG. 13** or **FIG. 14****.**

Receive codeblocks may be decoded **(S1506).**

A receiver may receive and decode codeblocks as discussed previously with reference to **FIGs 3-11****.**

A determination as to whether received codeblocks correspond to correct codeblocks associated with timeplan **1200** may be performed **(S1508).**

For a determination of not receiving codeblocks associated with timeplan **1200 (S1508),** a receiver may skip codeblocks until receiving a codeblock associated with timeplan **1200 (S1510).**

A receiver may ignore or disregard information received not associated with timeplan **1200.**

Following power-up, a received timeplan **1200** may not correspond with received information and a receiver may skip received information until received information corresponds with timeplan **1200.** For example, a timeplan may be modified synchronous with a receiver powering up and the received timeplan may be associated with information to be received at a later point in time.

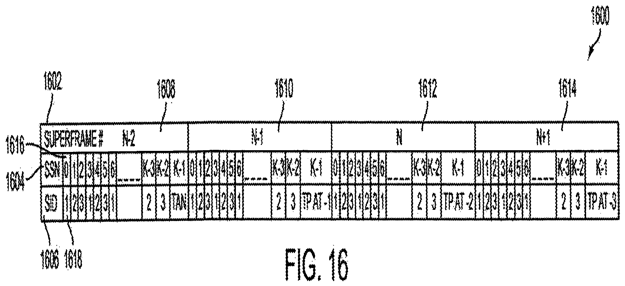

**FIG. 16** illustrates an arrangement **1600** of a plurality of superframes, in accordance with an aspect of the present disclosure.

Arrangement **1600** of a plurality of superframes includes a row **1602** of superframes, a row **1604** of SSNs and a row **1606** of SIDs. Row **1602** includes N-2 superframe **1608,** N-1 superframe **1610,** N superframe **1612,** and N+1 superframe **1614.** Row **1604** lists the SSNs within each superframe, whereas row **1606** lists the SIDs within each superframe.

Superframe **1608** includes a plurality of frames with a sampling sequence number 0 (SSN 0) denoted as **1616** presented with an SID having a value "1," as indicated by **1618.**

Sequence number **1616** may perform the same function as SSN **1202** discussed above with reference to **FIG. 12****.** SID **1618** may perform the same function as SID **1204** discussed above with reference to **FIG. 12****.**

Due to de-multiplexing of codeblocks as described with reference to **FIGs. 3-9****,** updating a timeplan for a receiver may require several codeblocks to perform. As a result of requiring several codeblocks for updating a timeplan, synchronization of timeplans with received information may be performed by transmitting updated timeplan information prior to implementation of the updated timeplan.

Furthermore, timeplan **1200 (****FIG. 12****)** may be communicated via a codeblock, for example outroute codeblock **402 (****FIG. 4****).** The codeblock location for transmission of timeplan **1200** with respect to a superframe, for example superframe **1608,** may repeatedly be transmitted via the same codeblock, for example outroute codeblock **402 (****FIG. 4****).**

For example, a system seeking to update a receiver timeplan during frame *x* may begin transmitting updated time plan information during the transmission of frame *x*-2, or two frames prior to implementation of the new timeplan. Prior to frame *x,* a receiver may continue to operate based upon the timeplan transmitted prior to frame *x*-2. Furthermore, once a timeplan has been transmitted to a receiver, the receiver may operate based on the updated timeplan (e.g. frame *x*).

In accordance with aspects of the present disclosure, a plurality of outroute data streams may be multiplexed at the transmitter side, thereby achieving multiple times greater data capacity than existing transmitters. Similarly, a received multiplexed data stream may be demultiplexed at the receiver side in order to achieve greater data capacity.

The de-multiplexer **620** used by the receiver **600** to reduce the amount of data processed by the receiver **600** may be a code block selector (CBS). The CBS may allow the receiver **600** to control the rate of the data presented to the processing elements down stream, such as the LDPC Decoder **622,** and to synchronize an internally stored timeplan, such as the timeplan **1200,** with the incoming data traffic from a transmitter, such as the transmitter **200.**

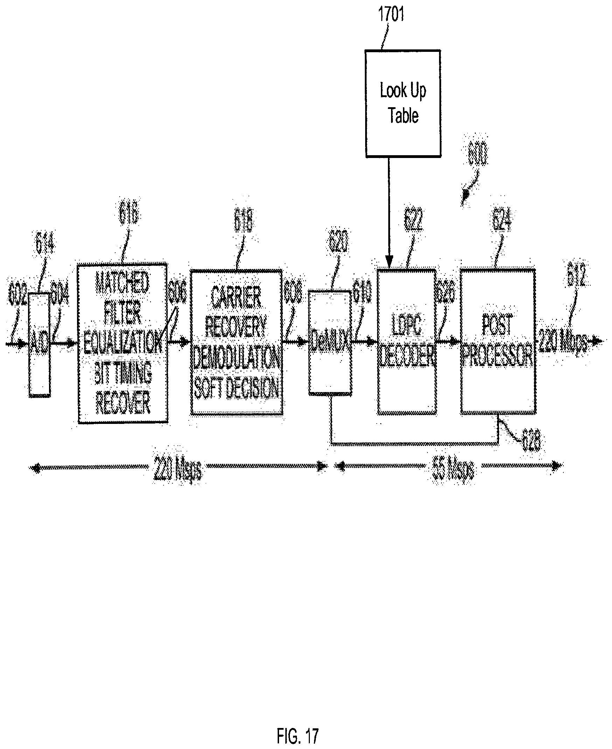

**FIG. 17** illustrates an example receiver with a code block selector. The CBS may be the de-multiplexer **620,** and may be a hardware block connected to the output of the demodulator **618.** For example, the CBS may be the first functional hardware block in a Forward Error Correction (FEC) unit of the Forward Channel Subsystem of an ASIC in the receiver **600.** The CBS may receive demodulated superframes from the demodulator **618,** and may select a subset of codeblocks, such as the codeblocks **402** and **410,** to be further processed by the receiver **600.** The CBS may use a Look Up Table (LUT) **1701** to determine which demodulated codeblocks to pass on for further processing. The LUT **1701** may be a table containing 1024 entries, which may correspond to the number of codeblocks in a superframe, such as the superframe **1608.** Each entry in the LUT **1701** may contain one bit. If an entry contains a value of "0", this may indicate that the corresponding codeblock should be blocked by the CBS. If the entry contains a value of "1", this may indicate that the corresponding codeblock should be passed on for further processing in the receiver **600.** Entries in the LUT **1701** may be based on, for example, the timeplan **1200** received by the receiver **600.**

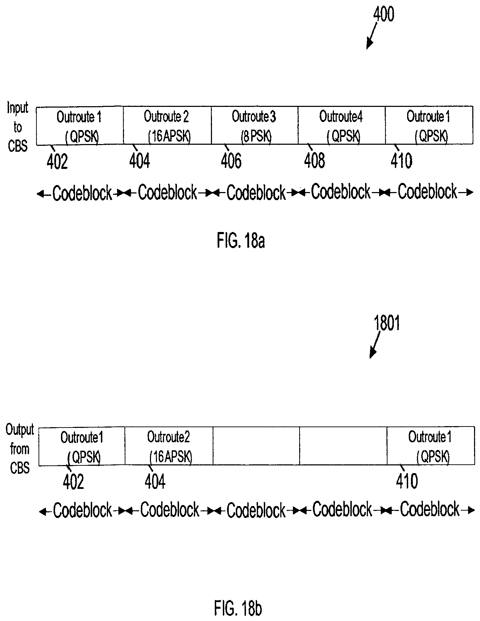

**FIGS. 18a and 18b** illustrate an example of codeblock input and output for a code block selector. The TDM codeblock data stream **400** received by the receiver **600** may include the codeblocks **402, 404, 406, 408, and 410,** which may be output from the demodulator **618b** to the de-multiplexer **620,** which may be the CBS. The CBS may check the LUT **1701** for each of the codeblocks **402, 404, 406, 408, and 410,** and may receive a response of "11001." This may indicate that the CBS should block the codeblocks **406** and **408,** corresponding to the outroute 3 **228** and the outroute 4 **230,** while passing the codeblocks **402, 404,** and **410,** corresponding to the outroute 1 **224** and the outroute 2 **226,** on for further processing in the receiver **600.** The CBS may output the de-multiplexed data stream **1801,** which may include the codeblocks **402, 404,** and **410.** This may result in the downstream processing elements of the receiver **600** not having to process the code blocks **406** and **408,** reducing the amount of processing power needed to handle the incoming data stream without requiring a reduction in the amount of data being sent by a transmitter, such as the transmitter **200.**

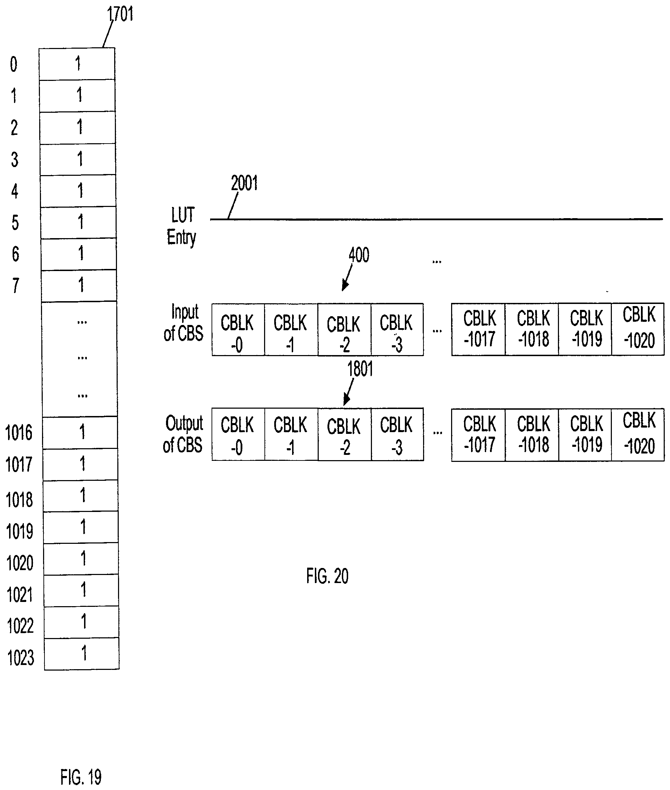

**FIG. 19** illustrates an exemplary look up table that passes every codeblock for processing. **FIG. 20** illustrates exemplary input and output of a code block selector that references a look up table that passes every code block for processing. The LUT **1701** may have all entries set to "1". This may indicate that all codeblocks in a data stream processed by the CBS are to be passed on for further processing. As depicted in **FIG. 20****,** when using the LUT 1701 where all entries are "1", when the CBS references the LUT **1701** to determine whether to pass on a codeblock from the TDM codeblock data stream **400,** the LUT **1701** may return a LUT entry **2001** of "1." This may cause the CBS to output all of the codeblocks from the TDM codeblock data stream **400** as de-multiplexed data stream **1801.** None of the codeblocks from the TDM codeblock data stream **400** may be dropped.

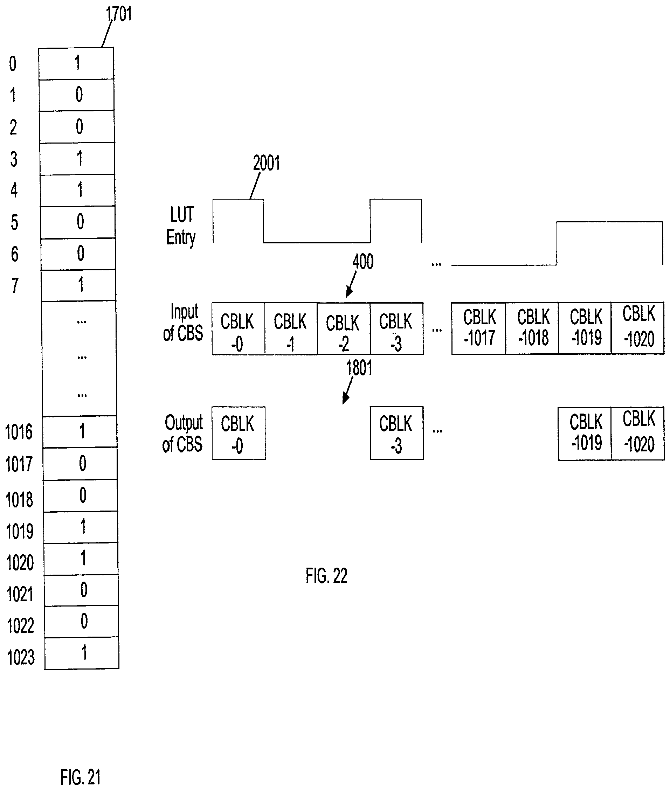

**FIG. 21** illustrates an exemplary look up table that passes 2 out of every 4 codeblocks for processing. **FIG. 22** illustrates exemplary input and output of a code block selector that references a look up table that passes 2 out of every 4 codeblocks for processing. The LUT **1701** may have a first entry set to "1", and then alternate between two "0" entries and two "1" entries. This may indicate 2 out of every 4 codeblocks in a data stream processed by the CBS are to be passed on for further processing. As depicted in **FIG. 22****,** when using the LUT 1701 where 2 out of every 4 codeblocks are to be passed on, when the CBS references the LUT **1701** to determine whether to pass on a codeblock from the TDM codeblock data stream **400,** the LUT **1701** may initially return the LUT entry **2001** as "1," followed by two "0" entries, followed by two "1" entries. This may cause the CBS to output 2 out of every 4 codeblocks from the TDM codeblock data stream **400** as de-multiplexed data stream **1801.** The first codeblock, CBLK-0, may be passed on based on the LUT entry **2001** of "1" as the initial entry, in position 0, of the LUT **1701.** The next two codeblocks, CBLK-1 and CBLK-2, may be dropped, based on the LUT entry **2001** of "0" in the next two positions in the LUT **1701.** This may be repeated for all 1024 entries in the LUT **1701,** starting over at the beginning of the **1701** once all of the codeblocks in the current superframe of the TDM codeblock data stream **400** have been processed by the CBS.

The entries in the LUT **1701** may pass on or drop the codeblocks in a superframe at any ratio. For example, as in **FIG. 19****,** the LUT **1701** may have a "1" for every entry, and pass on all codeblocks, or, as in **FIG. 21****,** may pass on half of the codeblocks. The LUT **1701** may pass on 2/3 of the codeblocks, or, if necessary, drop most or all of codeblocks.

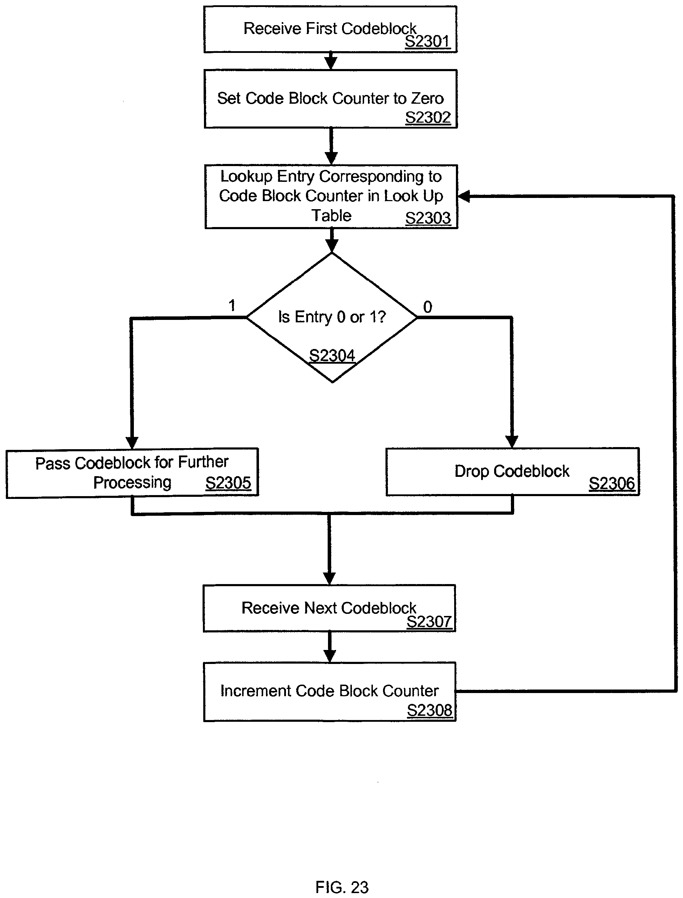

**FIG. 23** illustrates an example method of operating a code block selector with a look up table. The CBS may receive a first codeblock **(S2301).** For example, the receiver **600** may receive a superframe, which may be sent to the demodulator **618.** The demodulator may demodulate the superframe and send a first codeblock from the superframe to the de-multiplexer **620,** which may be the CBS.

Upon receiving the first codeblock, the CBS may set a Code Block Counter (CBS) to zero **(S2302).** The CBC may be a 10-bit number, from 0 to 1023, and may be used to address the LUT **1701.** The CBS may lookup the entry corresponding to the CBS in the LUT **1701 (S2303).** The first codeblock received by the CBS may cause the CBC to be set to 0, which may result in the CBS checking the first entry in the LUT **1701.** For subsequent codeblocks, the current value of the CBC may be used. For example, when the 10^{th} codeblock is received by the CBS, the CBC may be 9, so the CBS may check the 9^{th} entry in the LUT **1701.**

The CBS may determine if the looked up entry is a "1" or a "0" **(S2304).** If the entry in the LUT **1701** corresponding to the current CBC value is a "1", this may indicate the codeblock is to be passed on for further processing **(S2305).** Otherwise, if the entry is a "0", this may indicate the codeblock should be dropped by the CBS **(S2306).** For example, if the CBC is 5, and the entry in position 5 of the LUT **1701** is "1", the codeblock may be passed on from the CBS to the LPDC Decoder **622.** If the entry is position 5 were "0", the codeblock may be dropped by the CBS, and not processed any further.

Once the current codeblock has been processed by the CBS and dropped or passed on, the CBS may receive the next codeblock **(S2307).** The next codeblock in the superframe may be sent to the CBS from the demodulator **618.** Upon receiving the next codeblock, the CBS may increment the CBC **(S2308).** The incrementing of the CBC may ensure that the proper entry in the LUT **1701** is checked for the just received codeblock **(S2302).** For example, if CBS has just processed the first codeblock, with the CBS set to 0, and then received a second codeblock, the CBC may be incremented to 1. The incremented CBC may be used to check the LUT **1701** to determine what to do with the second codeblock. This may be repeated until the receiver **600** stops receiving a data stream.

Because the CBC may be a 10-bit number, the CBC may have a range of 0 to 1023, for 1024 distinct values, corresponding to the number of codeblocks in a superframe. The value of the CBS may correspond to the SSN **1202** of the codeblock being processed. When the last codeblock in a superframe is reached, the CBC may be at 1023, corresponding the SSN **1202** of 1023 of the last codeblock in the superframe. Incrementing the CBC at 1023 may result in the CBC being reset to 0, corresponding to the SSN **1202** of 0 of the first codeblock of the next superframe.

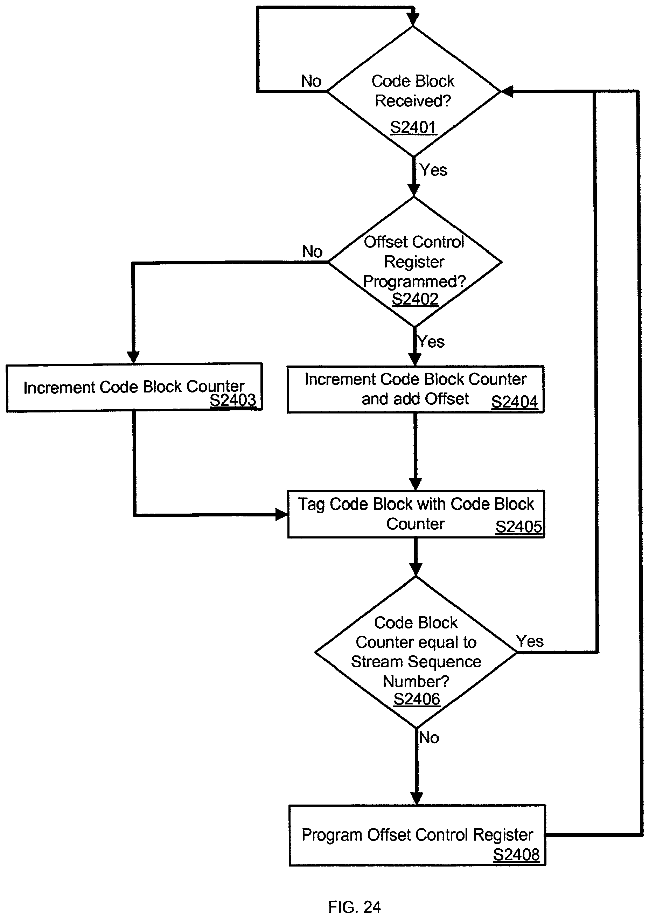

The CBS may not have access to the SSN **1202** in the BBHEADER **1108** of the codeblocks received from the demodulator **618.** When the CBS begins receiving codeblocks from the demodulator **618,** there may be a discrepancy between the CBC and the SSN **1202** for the incoming codeblocks. The CBS may need to be synchronized with the SSN **1202.** Downstream from the CBS, for example, at the post processor **624,** the SSN **1202** may be decoded for a received codeblock, and compared to CBC value received for the codeblock. The difference between the two values may be the offset, and may be written to an offset control register in the CBS. **FIG. 24** illustrates an example method of synchronizing the code block counter. The CBS may determine if a code block has been received **(S2401).** If a code block has not been received, the CBS may wait until a code block has been received **(S2401).** If a code block has been received, the CBS may check to see if an offset value has been written the offset control register **(S2402).** If no value has been written to the offset control register, the CBS may increment the CBC value **(S2403).** If a value has been written to the offset control register, the CBS may increment the CBC value, and then add the offset value to the resulting CBC value **(S2404).** For example, if the CBC value is 5, and the offset control register value is 3, the CBC may increment the CBC value to 6 and then add 3 for a CBC value of 9. After calculating the new CBC value, the CBS may tag the codeblock with the CBC value **(S2405).** At the post processor **624,** the CBC value of the codeblock may be compared with the SSN **1202** value for the codeblock **(S2406).** If the values are equal, the offset control register may be left unchanged. If the values are not equal, the difference between the values may be written to the offset control register, as the CBS may need to be synchronizes with the SSN's of the incoming codeblocks, locking the CBS to the incoming code block sequence.

The CBS may have access to more than one LUT **1701.** For example, there may be two LUT's **1701,** a Ping LUT and a Pong LUT, each of which may have entries based on a different timeplan. The CBS may be instructed to switch between the two LUT's by, for example, software on the receiver **600,** at any point in time, or at the end of a superframe. This may allow the receiver **600** and the CBS to operate with, and switch between, two or more separate timeplans.

## Claims

1. A receiver (600) for receiving a third plurality of code blocks based on a first plurality of code blocks and a second plurality of code blocks, the first plurality of code blocks being based on a first input signal, the second plurality of code blocks being based on a second input signal, each of the first plurality of code blocks having a first sequence number associated therewith and being modulated with a first modulation scheme, each of the second plurality of code blocks having a second sequence number associated therewith and being modulated with a second modulation scheme, the second modulation scheme being different than the first modulation scheme, each of the third plurality of code blocks formed as a multiplex of a respective one of the first plurality of code blocks and the second plurality of code blocks, said receiver comprising:
a de-multiplexing portion (620) operable to output a de-multiplexed signal based on the third plurality of code blocks, the de-multiplexing portion (620) comprising a code block selector including a code block counter and in communication with a look up table (1701) stored within the receiver (600), the code block selector operable to select a plurality of code blocks from the third plurality of code blocks to output as the de-multiplexed signal based on entries in the look up table; and
a recovery portion operable to output a plurality of received code blocks based on the de-multiplexed signal;
wherein the code block selector is configured to:
receive a code block of the third plurality of code blocks,
increment the code block counter,
look up an entry in the look up table (1701) corresponding to the code block counter, and
output the code block for further processing or block the code block based on the entry in the look up table (1701);
wherein the receiver further comprises a post processor (624) configured to:
receive the code block if the code block was not blocked by the code block selector,
decode a stream sequence identifier from the code block,
determine an offset by comparing the stream sequence identifier to the code block counter, and
write the offset to a register of the code block selector;
wherein the code block selector is configured to add the offset to the code block counter responsive to determining that the offset has been written to the register to synchronize the code block counter with a stream sequence identifier of incoming code blocks of the third plurality of code blocks; and
wherein each of the entries in the look up table (1701) comprise one of:
(i) a value of "0" to indicate that the corresponding code block from the third plurality of code blocks should be blocked from being output as the de-multiplexed signal; or
(ii) a value of "1" to indicate that the corresponding code block from the third plurality of code blocks should be output as the de-multiplexed signal.

2. The receiver of claim 1, wherein the entries in the look up table (1701) are based on a timeplan in a received planning code block.

3. The receiver of claim 1, wherein the code block selector is operable to set the value of the code block counter to zero responsive to determining the code block of the third plurality of code blocks is a first code block in at least one of a superframe, a sequence of code blocks, and a data stream.

4. The receiver of claim 1, wherein the look up table includes a same number of entries as a number of the third plurality of code blocks to be received in at least one of a superframe, a sequence of code blocks, and a data stream.

5. The receiver of claim 1, wherein the plurality of received code blocks includes the first plurality of code blocks and is modulated with the first modulation scheme.

6. The receiver of claim 1, further comprising:
a second lookup table comprising a plurality of entries wherein the code block selector is further configured to switch between the lookup table (1701) and the second lookup table.

7. The receiver of claim 1, wherein the code block counter has a range of 0 to 1023.

8. A method of receiving a third plurality of code blocks based on a first plurality of code blocks and a second plurality of code blocks, the first plurality of code blocks being based on a first input signal, the second plurality of code blocks being based on a second input signal, each of the first plurality of code blocks having a first sequence number associated therewith and being modulated with a first modulation scheme, each of the second plurality of code blocks having a second sequence number associated therewith and being modulated with a second modulation scheme, the second modulation scheme being different than the first modulation scheme, each of the third plurality of code blocks formed as a multiplex of a respective one of the first plurality of code blocks and the second plurality of code blocks, said method comprising:
generating, via a de-multiplexing portion (620), a de-multiplexed signal based on the third plurality of code blocks, the de-multiplexing portion (620) selecting a plurality of code blocks from the third plurality of code blocks to output as the de-multiplexed signal based on entries in a look up table (1701) by:
receiving a code block of the third plurality of code blocks,
incrementing a code block counter,
looking up an entry in the look up table (1701) corresponding to the code block counter, and
outputting the code block for further processing or blocking the code block based on the entry in the look up table (1701);
outputting, via a recovery portion, a plurality of received code blocks based on the de-multiplexed signal;
processing, via a post processor (624), the code block by:
receiving the code block if the code block was not blocked by the de-multiplexing portion (620),
decoding a stream sequence identifier from the code block,
determining an offset by comparing the stream sequence identifier to the code block counter, and
writing the offset to a register of the de-multiplexing portion (620); and
adding, via the de-multiplexing portion (620), the offset to the code block counter responsive to determining that the offset has been written to the register to synchronize the code block counter with a stream sequence identifier of incoming code blocks of the third plurality of code blocks;
wherein each of the entries in the look up table (1701) comprise one of:
(i) a value of "0" to indicate that the corresponding code block from the third plurality of code blocks should be blocked from being output as the de-multiplexed signal; or
(ii) a value of "1" to indicate that the corresponding code block from the third plurality of code blocks should be output as the de-multiplexed signal.

9. The method of claim 8, further comprising setting, via the de-multiplexing portion (620), the value of the code block counter to zero responsive to determining the code block of the third plurality of code blocks is a first code block in at least one of a superframe, a sequence of code blocks, and a data stream.

10. The method of claim 8, wherein the look up table (1701) includes a same number of entries as a number of the third plurality of code blocks to be received in at least one of a superframe, a sequence of code blocks, and a data stream.

11. The method of claim 8, wherein the plurality of received code blocks includes the first plurality of code blocks and is modulated with the first modulation scheme.

12. The method of claim 8, wherein the code block counter has a range of 0 to 1023.

## Patentansprüche

1. Empfänger (600) zum Empfangen einer dritten Vielzahl von Codeblöcken auf Basis einer ersten Vielzahl von Codeblöcken und einer zweiten Vielzahl von Codeblöcken, wobei die erste Vielzahl von Codeblöcken auf einem ersten Eingangssignal basiert, die zweite Vielzahl von Codeblöcken auf einem zweiten Eingangssignal basiert, wobei jeder der ersten Vielzahl von Codeblöcken eine erste Sequenznummer aufweist, die ihm zugeordnet ist, und mit einem ersten Modulationsschema moduliert ist, jeder der zweiten Vielzahl von Codeblöcken eine zweite Sequenznummer aufweist, die ihm zugeordnet ist, und mit einem zweiten Modulationsschema moduliert ist, wobei das zweite Modulationsschema von dem ersten Modulationsschema verschieden ist, wobei jeder der dritten Vielzahl von Codeblöcken als Multiplex aus einem jeweiligen Codeblock der ersten Vielzahl von Codeblöcken und der zweiten Vielzahl von Codeblöcken gebildet ist, und wobei der Empfänger Folgendes umfasst:
einen Demultiplexierungsabschnitt (620), der dazu nutzbar ist, ein demultiplextes Signal auf Basis der dritten Vielzahl von Codeblöcken auszugeben, wobei der Demultiplexierungsabschnitt (620) einen Codeblockwahlschalter umfasst, der einen Codeblockzähler enthält und in Verbindung mit einer im Empfänger (600) gespeicherten Nachschlagetabelle (1701) steht, wobei der Codeblockwahlschalter dazu nutzbar ist, mehrere Codeblöcke aus der dritten Vielzahl von Codeblöcken auszuwählen, um sie auf Basis von Einträgen in der Nachschlagetabelle als demultiplextes Signal auszugegeben; und
einen Wiederherstellungsabschnitt, der dazu nutzbar ist, auf Basis des demultiplexten Signals eine Vielzahl empfangener Codeblöcke auszugeben;
wobei der Codeblockwahlschalter dazu ausgelegt ist:
einen Codeblock der dritten Vielzahl von Codeblöcken zu empfangen,
den Codeblockzähler zu inkrementieren,
einen Eintrag in der Nachschlagetabelle (1701) nachzuschlagen, der dem Codeblockzähler entspricht, und
den Codeblock auf Basis des Eintrags in der Nachschlagetabelle (1701) zur Weiterverarbeitung auszugeben oder den Codeblock zu sperren;
wobei der Empfänger ferner einen Postprozessor (624) umfasst, der dazu ausgelegt ist:
den Codeblock zu empfangen, wenn der Codeblock nicht durch den Codeblockwahlschalter gesperrt wurde,
eine Stream-Sequenzkennung aus dem Codeblock zu decodieren,
einen Offset durch Vergleichen der Stream-Sequenzkennung mit dem Codeblockzähler zu bestimmen, und
den Offset in ein Register des Codeblockwahlschalters zu schreiben;
wobei der Codeblockauswahlschalter dazu ausgelegt ist, den Offset als Reaktion auf die Feststellung, dass der Offset in das Register geschrieben wurde, zum Codeblockzähler hinzuzufügen, um den Codeblockzähler mit einer Stream-Sequenzkennung des eingehenden Codeblocks der dritten Vielzahl von Codeblöcken zu synchronisieren; und
wobei jeder der Einträge in der Nachschlagetabelle (1701) einen der folgenden Werte umfasst:
(i) einen Wert von "0", um anzuzeigen, dass der entsprechende Codeblock aus der dritten Vielzahl von Codeblöcken daran gehindert werden soll, als das demultiplexte Signal ausgegeben zu werden; oder
(ii) einen Wert von "1", um anzuzeigen, dass der entsprechende Codeblock aus der dritten Vielzahl von Codeblöcken als das demultiplexte Signal ausgegeben werden soll.

2. Empfänger nach Anspruch 1, wobei die Einträge in der Nachschlagetabelle (1701) auf einem Zeitplan in einem empfangenen Planungs-Codeblock basieren.

3. Empfänger nach Anspruch 1, wobei der Codeblockauswahlschalter dazu nutzbar ist, den Wert des Codeblockzählers als Reaktion darauf, dass der Codeblock der dritten Vielzahl von Codeblöcken als ein erster Codeblock in mindestens einem von einem Superframe, einer Sequenz von Codeblöcken und einem Datenstrom bestimmt wird, auf null zu setzen.

4. Empfänger nach Anspruch 1, wobei die Nachschlagetabelle eine gleiche Anzahl von Einträgen wie eine Anzahl der dritten Vielzahl von Codeblöcken beinhaltet, die in mindestens einem von einem Superframe, einer Sequenz von Codeblöcken und einem Datenstrom empfangen werden sollen.

5. Empfänger nach Anspruch 1, wobei die Vielzahl der empfangenen Codeblöcke die erste Vielzahl von Codeblöcken beinhaltet und mit dem ersten Modulationsschema moduliert ist.

6. Empfänger nach Anspruch 1, ferner umfassend:
eine zweite Nachschlagetabelle, die eine Vielzahl von Einträgen umfasst, wobei der Codeblockwahlschalter ferner dazu ausgelegt ist, zwischen der Nachschlagetabelle (1701) und der zweiten Nachschlagetabelle zu wechseln.

7. Empfänger nach Anspruch 1, wobei der Codeblockzähler einen Bereich von 0 bis 1023 aufweist.

8. Verfahren zum Empfangen einer dritten Vielzahl von Codeblöcken auf Basis auf einer ersten Vielzahl von Codeblöcken und einer zweiten Vielzahl von Codeblöcken, wobei die erste Vielzahl von Codeblöcken auf einem ersten Eingangssignal basiert, die zweite Vielzahl von Codeblöcken auf einem zweiten Eingangssignal basiert, wobei jeder der ersten Vielzahl von Codeblöcken eine erste Sequenznummer aufweist, die ihm zugeordnet ist, und mit einem ersten Modulationsschema moduliert ist, jeder der zweiten Vielzahl von Codeblöcken eine zweite Sequenznummer aufweist, die ihm zugeordnet ist, und mit einem zweiten Modulationsschema moduliert ist, wobei das zweite Modulationsschema von dem ersten Modulationsschema verschieden ist, wobei jeder der dritten Vielzahl von Codeblöcken als Multiplex aus einem jeweiligen Codeblock der ersten Vielzahl von Codeblöcken und der zweiten Vielzahl von Codeblöcken gebildet ist, und wobei das Verfahren Folgendes umfasst:
Generieren eines demultiplexten Signals über einen Demultiplexierungsabschnitt (620) auf Basis der dritten Vielzahl von Codeblöcken, wobei der Demultiplexierungsabschnitt (620) mehrere Codeblöcke aus der dritten Vielzahl von Codeblöcken auswählt, um sie auf Basis von Einträgen in einer Nachschlagetabelle (1701) als das demultiplexte Signal auszugegeben durch:
Empfangen eines Codeblocks der dritten Vielzahl von Codeblöcken,
Inkrementieren eines Codeblockzählers,
Nachschlagen eines Eintrags in der Nachschlagetabelle (1701), der dem Codeblockzähler entspricht, und
Ausgeben des Codeblocks zur Weiterverarbeitung oder Sperre des Codeblocks auf Basis des Eintrags in der Nachschlagetabelle (1701);
Ausgeben mehrerer empfangener Codeblöcke auf Basis des demultiplexten Signals über einen Wiederherstellungsabschnitt;
Verarbeiten des Codeblocks über einen Postprozessor (624) durch:
Empfangen des Codeblocks, wenn der Codeblock nicht durch den Demultiplexierungsabschnitt (620) gesperrt wurde,
Decodieren einer Stream-Sequenzkennung aus dem Codeblock,
Bestimmen eines Offsets durch Vergleichen der Stream-Sequenzkennung mit dem Codeblockzähler, und
Schreiben des Offsets in ein Register des Demultiplexierungsabschnitts (620);
und
Hinzufügen des Offsets zum Codeblockzähler über den Demultiplexierungsabschnitt (620) als Reaktion auf die Feststellung, dass der Offset in das Register geschrieben wurde, um den Codeblockzähler mit einer Stream-Sequenzkennung des eingehenden Codeblocks der dritten Vielzahl von Codeblöcken zu synchronisieren;
wobei jeder der Einträge in der Nachschlagetabelle (1701) einen der folgenden Werte umfasst:
(i) einen Wert von "0", um anzuzeigen, dass der entsprechende Codeblock aus der dritten Vielzahl von Codeblöcken daran gehindert werden soll, als das demultiplexte Signal ausgegeben zu werden; oder
(ii) einen Wert von "1", um anzuzeigen, dass der entsprechende Codeblock aus der dritten Vielzahl von Codeblöcken als das demultiplexte Signal ausgegeben werden soll.

9. Verfahren nach Anspruch 8, ferner umfassend das Einstellen des Wertes des Codeblockzählers über den Demultiplexierungsabschnitt (620) auf null als Reaktion auf die Feststellung, dass der Codeblock der dritten Vielzahl von Codeblöcken ein erster Codeblock in mindestens einem von einem Superframe, einer Sequenz von Codeblöcken und einem Datenstrom ist.

10. Verfahren nach Anspruch 8, wobei die Nachschlagetabelle (1701) eine gleiche Anzahl von Einträgen wie eine Anzahl der dritten Vielzahl von Codeblöcken beinhaltet, die in mindestens einem von einem Superframe, einer Sequenz von Codeblöcken und einem Datenstrom empfangen werden sollen.

11. Verfahren nach Anspruch 8, wobei die Vielzahl der empfangenen Codeblöcke die erste Vielzahl von Codeblöcken beinhaltet und mit dem ersten Modulationsschema moduliert ist.

12. Verfahren nach Anspruch 8, worin der Codeblockzähler einen Bereich von 0 bis 1023 aufweist.

## Revendications

1. Récepteur (600) destiné à recevoir une troisième pluralité de blocs de code sur la base d'une première pluralité de blocs de code et d'une deuxième pluralité de blocs de code, la première pluralité de blocs de code étant basée sur un premier signal d'entrée, la deuxième pluralité de blocs de code étant basée sur un second signal d'entrée, chacun de la première pluralité de blocs de code ayant un premier numéro de séquence y associé et étant modulé avec un premier schéma de modulation, chacun de la deuxième pluralité de blocs de code ayant un second numéro de séquence y associé et étant modulé avec un second schéma de modulation, le second schéma de modulation étant différent du premier schéma de modulation, chacun de la troisième pluralité de blocs de code étant formé en tant que multiplex de l'un respectif de la première pluralité de blocs de code et de la deuxième pluralité de blocs de code, ledit récepteur comprenant :
une partie de démultiplexage (620) pouvant être utilisée pour produire en sortie un signal démultiplexé sur la base de la troisième pluralité de blocs de code, la partie de démultiplexage (620) comprenant un sélecteur de blocs de code comprenant un compteur de blocs de code et en communication avec une table de recherche (1701) stockée dans le récepteur (600), le sélecteur de blocs de code pouvant être utilisé pour sélectionner une pluralité de blocs de code à partir de la troisième pluralité de blocs de code à produire en sortie en tant que signal démultiplexé sur la base de saisies dans la table de recherche ; et
une partie de récupération pouvant être utilisée pour produire en sortie une pluralité de blocs de code sur la base du signal démultiplexé ;
dans lequel le sélecteur de blocs de code est configuré pour :
recevoir un bloc de code de la troisième pluralité de blocs de code,
incrémenter le compteur de blocs de code,
rechercher une saisie dans la table de recherche (1701) correspondant au compteur de blocs de code, et
produire en sortie le bloc de code pour un traitement ultérieur ou bloquer le bloc de code sur la base de la saisie dans la table de recherche (1701) ;
dans lequel le récepteur comprend en outre un postprocesseur (624) configuré pour :
recevoir le bloc de code si le bloc de code n'a pas été bloqué par le sélecteur de blocs de code,
décoder un identifiant de séquence de flux à partir du bloc de code,
déterminer un décalage en comparant l'identifiant de séquence de flux au compteur de blocs de code, et
écrire le décalage sur un registre du sélecteur de blocs de code ;
dans lequel le sélecteur de blocs de code est configuré pour ajouter le décalage au compteur de blocs de code en réponse à la détermination du fait que le décalage a été écrit sur le registre pour synchroniser le compteur de blocs de code avec un identifiant de séquence de flux de blocs de code entrants de la troisième pluralité de blocs de code ; et
dans lequel chacune des saisies dans le table de recherche (1701) comprend l'une de :
(i) une valeur de « 0 » pour indiquer que le bloc de code correspondant à partir de la troisième pluralité de blocs de code devrait être empêché d'être produit en sortie en tant que signal démultiplexé ; ou
(ii) une valeur de « 1 » pour indiquer que le bloc de code correspondant à partir de la troisième pluralité de blocs de code devrait être produit en sortie en tant que signal démultiplexé.

2. Récepteur selon la revendication 1, dans lequel les saisies dans la table de recherche (1701) sont basées sur un calendrier dans un bloc de code de planification reçu.

3. Récepteur selon la revendication 1, dans lequel le sélecteur de blocs de code peut être utilisé pour définir la valeur du compteur de blocs de code sur zéro en réponse à la détermination du fait que le bloc de code de la troisième pluralité de blocs de code est un premier bloc de code dans au moins l'un d'une supertrame, d'une séquence de blocs de code et d'un flux de données.

4. Récepteur selon la revendication 1, dans lequel la table de recherche comprend un même nombre de saisies en tant que nombre de la troisième pluralité de blocs de code à recevoir dans au moins l'un d'une supertrame, d'une séquence de blocs de code et d'un flux de données.

5. Récepteur selon la revendication 1, dans lequel la pluralité de blocs de code reçus comprend la première pluralité de blocs de code et est modulée avec le premier schéma de modulation.

6. Récepteur selon la revendication 1, comprenant en outre :
une seconde table de recherche comprenant une pluralité de saisies dans lequel le sélecteur de blocs de code est en outre configuré pour basculer entre la table de recherche (1701) et la seconde table de recherche.

7. Récepteur selon la revendication 1, dans lequel le compteur de blocs de code a une plage de 0 à 1 023.

8. Procédé de réception d'une troisième pluralité de blocs de code sur la base d'une première pluralité de blocs de code et d'une deuxième pluralité de blocs de code, la première pluralité de blocs de code étant basée sur un premier signal d'entrée, la deuxième pluralité de blocs de code étant basée sur un second signal d'entrée, chacun de la première pluralité de blocs de code ayant un premier numéro de séquence y associé et étant modulé avec un premier schéma de modulation, chacun de la deuxième pluralité de blocs de code ayant un second numéro de séquence y associé et étant modulé avec un second schéma de modulation, le second schéma de modulation étant différent du premier schéma de modulation, chacun de la troisième pluralité de blocs de code étant formé en tant que multiplex de l'un respectif de la première pluralité de blocs de code et de la deuxième pluralité de blocs de code, ledit procédé comprenant :
la génération, via une partie de démultiplexage (620), d'un signal démultiplexé sur la base de la troisième pluralité de blocs de code, la partie de démultiplexage (620) sélectionnant une pluralité de blocs de code à partir de la troisième pluralité de blocs de code à produire en sortie en tant que signal démultiplexé sur la base de saisies dans une table de recherche (1701) en :
recevant un bloc de code de la troisième pluralité de blocs de code,
incrémentant un compteur de blocs de code,
recherchant une saisie dans la table de recherche (1701) correspondant au compteur de blocs de code, et en
produisant en sortie le bloc de code pour un traitement ultérieur ou en bloquant le bloc de code sur la base de la saisie dans la table de recherche (1701) ;
la production en sortie, via une partie de récupération, d'une pluralité de blocs de code reçus sur la base du signal démultiplexé ;
le traitement, via un postprocesseur (624), du bloc de code en :
recevant le bloc de code si le bloc de code n'a pas été bloqué par la partie de démultiplexage (620),
le décodage d'un identifiant de séquence de flux à partir du bloc de code,
la détermination d'un décalage en comparant l'identifiant de séquence de flux au compteur de blocs de code, et
l'écriture du décalage sur un registre de la partie de démultiplexage (620) ; et
l'ajout, via la partie de démultiplexage (620), du décalage au compteur de blocs de code en réponse à la détermination du fait que le décalage a été écrit sur le registre pour synchroniser le compteur de blocs de code avec un identifiant de séquence de flux de blocs de code entrants de la troisième pluralité de blocs de code ;
dans lequel chacune des saisies dans la table de recherche (1701) comprend l'une de :
(i) une valeur de « 0 » pour indiquer que le bloc de code correspondant à partir de la troisième pluralité de blocs de code devrait être empêché d'être produit en sortie en tant que signal démultiplexé ; ou
(ii) une valeur de « 1 » pour indiquer que le bloc de code correspondant à partir de la troisième pluralité de blocs de code devrait être produit en sortie en tant que signal démultiplexé.

9. Procédé selon la revendication 8, comprenant en outre la définition, via la partie de démultiplexage (620), de la valeur du compteur de blocs de code sur zéro en réponse à la détermination du fait que le bloc de code de la troisième pluralité de blocs de code est un premier bloc de code dans au moins l'un d'une supertrame, d'une séquence de blocs de code et d'un flux de données.

10. Procédé selon la revendication 8, dans lequel la table de recherche (1701) comprend un même nombre de saisies en tant que nombre de la troisième pluralité de blocs de code à recevoir dans au moins l'un d'une supertrame, d'une séquence de blocs de code et d'un flux de données.

11. Procédé selon la revendication 8, dans lequel la pluralité de blocs de code reçus comprend la première pluralité de blocs de code et est modulée avec le premier schéma de modulation.

12. Procédé selon la revendication 8, dans lequel le compteur de blocs de code a une plage de 0 à 1 023.
